# EUROPEAN PATENT SPECIFICATION

(11) **EP 4 508 831 B1**
(45) Date of publication and mention of the grant of the patent: **02.12.2026**
(21) Application number: 23717532.8
(22) Date of filing: 06.04.2023
(51) Int. Cl.: H04N 9/31, G02B 26/10, H01S 5/062

(54) **LASER CIRCUIT WITH TWO SUPPLY TERMINALS AND METHOD FOR OPERATING A LASER CIRCUIT**
LASERSCHALTUNG MIT ZWEI VERSORGUNGSANSCHLÜSSEN SOWIE VERFAHREN ZUM BETREIBEN EINER LASERSCHALTUNG
CIRCUIT LASER À DEUX BORNES D'ALIMENTATION ET PROCÉDÉ DE FONCTIONNEMENT D'UN CIRCUIT LASER

(30) Priority: 12.04.2022 DE 102022108875
(43) Date of publication of application: 19.02.2025
(73) Proprietor: ams Sensors Belgium BV, 2600 Antwerpen (BE)
(72) Inventor: POLTORAK, Karolina, 1183 Bursins (CH); GANCARZ, Radoslaw, 8134 Adliswil (CH)
(74) Representative: Epping - Hermann - Fischer
(86) International application number: PCT/EP2023/059185
(87) International publication number: WO 2023/198607

(56) References cited:
- US-A1- 2009 195 700
- US-A1- 2012 140 784
- US-A1- 2018 284 442
- US-A1- 2020 296 337
- TAJFAR ALIREZA ET AL: "High-Speed Low-Power 4 Channel Laser Diode Driver for Pico-Projector Application", 2018 2ND EUROPEAN CONFERENCE ON ELECTRICAL ENGINEERING AND COMPUTER SCIENCE (EECS), IEEE, 20 December 2018 (2018-12-20), pages 371 - 375, XP033641784, DOI: 10.1109/EECS.2018.00075

## Description

This patent application claims the priority of German patent application 10 2022 108 875. 8

The present disclosure is related to a laser circuit with two supply terminals and to a method for operating a laser circuit.

A laser circuit typically provides radiation in form of pulses. The radiation is e.g. light in the visible range. The radiation is e.g. light in the red, green and/or blue range. The radiation intensity is controlled by a laser current that flows through the laser. Laser circuits can be used in different markets such as automotive, aerospace, consumer, industry, augmented reality, mixed reality and/or virtual reality. A laser typically is supplied by a high voltage. However, this high voltage may not be compatible with an integrated circuit.

Document US 2009/0195700 A1 describes a method and an apparatus for controlling the output of a laser diode or light emitting diode. A video signal is provided via an amplifier circuit and a capacitor to a first terminal of a light emitting diode.

Document US 2020/0296337 A1 shows a control device for a laser scanning display apparatus including a laser device, a current source that generates an electric current supplied to the laser device, and a controller that controls the current source to set a current value of the electric current supplied to the laser device. For example, a laser controller is coupled via a main controller and a laser driver to a laser module. The laser driver comprises a current source.

It is an object to provide a laser circuit with a two supply terminals and a method for operating a laser circuit with an improved amended supply voltage.

These objects are achieved by the subject matter of the independent claims. Further embodiments and developments are given in the dependent claims.

According to an embodiment, a laser circuit comprises a video digital-to-analog converter, a laser with a first and a second terminal, a first supply terminal which is coupled via the video digital-to-analog converter to the first terminal of the laser and a second supply terminal which is coupled to the second terminal of the laser.

A first supply voltage is provided at the first supply terminal. A second supply voltage is provided at the second supply terminal. The first supply voltage is e.g. higher than a ground potential. The second supply voltage is e.g. lower than the ground potential.

Advantageously, the second supply voltage is negative. The operation of the laser mainly depends on the difference between the first supply voltage and the second supply voltage. Thus, the video digital-to-analog converter can be operated and controlled with voltages with a relative low height. This reduces the effort of level shifting of the signals in the laser circuit.

According to a further embodiment of the laser circuit, the video digital-to-analog converter is realized as current source circuit.

According to a further embodiment, the laser circuit comprises a reference potential terminal. The ground potential is provided at the reference potential terminal. The reference potential terminal is not directly connected to the first supply terminal and is not directly connected to the second supply terminal.

According to a further embodiment, the laser circuit comprises a digital circuit coupled to the reference potential terminal. The digital circuit has an output coupled to a control input of the video digital-to-analog converter.

According to a further embodiment of the laser circuit, the digital circuit is coupled to the first supply terminal or to a digital supply terminal, e.g. for supply of the digital circuit. A digital supply voltage is provided at the digital supply terminal. The digital supply voltage is e.g. between the first supply voltage and the ground potential or equal to the first supply voltage.

In an example, the digital circuit is additionally coupled to a supply terminal at which a supply voltage is provided. The supply voltage of the digital circuit is lower or equal to the first supply voltage but higher than the ground potential. The difference between the supply voltage of the digital circuit and the ground potential is appropriate for operation of the digital circuit. In the limit case, the supply voltage of the digital circuit is equal to the first supply voltage.

According to a further embodiment, the laser circuit comprises a level shifter having an input coupled to the digital circuit and an output coupled to the control input of the video digital-to-analog converter.

According to an alternative embodiment, the laser circuit is free of a level shifter having an input coupled to the digital circuit and an output coupled to the control input of the video digital-to-analog converter.

According to a further embodiment of the laser circuit, the video digital-to-analog converter comprises a first number N of series circuits. A series circuit of the first number N of series circuits comprises a converter switch and a current regulator. The current regulator is e.g. realized as a single current source.

According to a further embodiment, the laser circuit comprises a bias digital-to-analog converter. The first supply terminal is coupled via the bias digital-to-analog converter to the first terminal of the laser.

According to a further embodiment of the laser circuit, the bias digital-to-analog converter is realized as current source circuit.

According to a further embodiment, the laser circuit includes a threshold digital-to-analog converter that is coupled to the first terminal of the laser.

According to a further embodiment, the laser circuit includes a gain digital-to-analog converter having an output coupled to an input of the video digital-to-analog converter.

According to a further embodiment, the laser circuit comprises a further video digital-to-analog converter, a further laser with a first and a second terminal and a further supply terminal which is coupled to the second terminal of the further laser. The first supply terminal is coupled via the further video digital-to-analog converter to the first terminal of the further laser. A further supply voltage is provided at the further supply terminal. The further supply voltage is e.g. lower than the ground potential.

According to a further embodiment, the laser circuit comprises an additional video digital-to-analog converter, an additional laser with a first and a second terminal, and an additional supply terminal which is coupled to the second terminal of the additional laser. The first supply terminal is coupled via the additional video digital-to-analog converter to the first terminal of the additional laser. An additional supply voltage is provided at the additional supply terminal. The additional supply voltage is e.g. lower than the ground potential.

According to an embodiment, a method for operating a laser circuit comprises:
- providing a first supply voltage to a video digital-to-analog converter,
- providing a video signal current by the video digital-to-analog converter,
- providing a second supply voltage to a laser, and
- emitting radiation by the laser as a function of the video signal current.

The first supply voltage is e.g. higher than a ground potential and the second supply voltage is e.g. lower than the ground potential.

In an example, the laser circuit generates the second supply voltage as a common voltage for a number of lasers or the laser circuit generates different values of the second supply voltage in order to adjust each laser separately.

According to a further embodiment, the method comprises providing a threshold current by a threshold digital-to-analog converter and emitting radiation by the laser in addition as a function of the threshold current.

According to a further embodiment, the method comprises providing a bias current by a bias digital-to-analog converter and emitting radiation by the laser in addition as a function of the bias current.

In an example, the laser circuit which can be named driver has signals between ground potential and the first supply voltage provided at the first supply terminal. The first and the second terminal of the laser has a first and a second potential. And by lowering the second potential of the second laser terminal, the first potential of the first terminal of the laser can be also lowered and therefore signal swing at the laser circuit can be lowered, especially at the digital circuit. Advantageously, level shifting of signals at the laser circuit can be reduced or removed.

According to a further embodiment, a laser circuit comprises a video digital-to-analog converter, a bias digital-to-analog converter and a laser with a first and a second terminal. The first terminal of the laser is coupled to the video digital-to-analog converter and to the bias digital-to-analog converter. The video digital-to-analog converter is configured to provide a video signal current having a pulse form. The bias digital-to-analog converter is configured to provide a bias current. A value of the bias current is smaller than a laser threshold value of the laser. A laser current comprises the video signal current and the bias current. In case of a pulse of the video signal current, the laser current is higher than the laser threshold value.

Advantageously, the use of two digital-to-analog converters provides a high flexibility for generating the laser current for the laser. The laser current flows through the laser. For example, fluctuations of the laser current due to temperature shifts are reduced. The video signal current includes e.g. a series of pulses with different amplitudes. For example, the laser current can be properly adjusted to follow the change of laser electro-optical characteristics due to laser temperature shifts.

According to a further embodiment of the laser circuit, the video digital-to-analog converter and the bias digital-to-analog converter are realized as current sink circuits.

According to an alternative embodiment of the laser circuit, the video digital-to-analog converter and the bias digital-to-analog converter are realized as current source circuits.

According to a further embodiment of the laser circuit, the video digital-to-analog converter has a wider current range than a desired current range over the laser threshold value.

According to a further embodiment of the laser circuit, the video digital-to-analog converter has a first step size and the bias digital-to-analog converter has a second step size. The first step size is smaller than the second step size. For example, the steps between consecutive setable current values of the laser current are smaller in the video digital-to-analog converter in comparison to the bias digital-to-analog converter.

According to a further embodiment of the laser circuit, the bias current flows through the laser. The laser emits radiation when the laser current is higher than the laser threshold value. Since the value of the bias current is smaller than the laser threshold value of the laser, the laser does not emit radiation in case only the bias current flows through the laser.

According to a further embodiment of the laser circuit, the video signal current flows through the laser. The video signal current includes pulses with different amplitudes. In case the sum of a pulse of the video signal current and of the bias current is higher than the laser threshold value of the laser, the laser emits radiation. Only at non zero video data pulses are generated and the laser current is higher than the laser threshold value. In durations between the pulses, the laser current is below the laser threshold value.

According to a further embodiment of the laser circuit, a duration of a pulse of the bias current is longer than a duration of a pulse of the video signal current. Typically, the bias current is e.g. a DC current. The bias current is different from zero for several periods.

According to a further embodiment of the laser circuit, during interruption of the operation of the laser circuit and/or during a period that is free from a pulse of the video signal current and/or during a number F of periods that are free from a pulse of the video signal current, wherein the number F is larger than 1, the bias digital-to-analog converter is configured to provide the bias current with a value lower than a value of the bias current in a period with a pulse of the video signal current. In an example, during one of the situations described above, the bias current is switched off or is in a range between 0% and 10% of the laser threshold value. The bias current is switched off means the bias current is zero.

According to a further embodiment, the laser circuit is configured to check a control signal, especially the next value of the control signal or a number F of values of the control signal, whether the next period is free of a pulse or the next number F of periods are free of a pulse in order to reduce the bias current as described above. The control signal is applied to the laser circuit.

The bias current in a range between 0% and 10% of the laser threshold value means that the bias current has a value zero or a value less than 10% of the laser threshold value.

According to a further embodiment of the laser circuit, the laser circuit includes a threshold digital-to-analog converter that is coupled to the first terminal of the laser. The threshold digital-to-analog converter provides a threshold current that flows through the laser. A sum of the bias current and of the threshold current is equal or below the laser threshold value of the laser. The bias current and the threshold current sum up to the laser threshold value or a bit below the laser threshold value. The laser current comprises the video signal current, the bias current and the threshold current. In case of a pulse of the video signal current, the laser current is higher than the laser threshold value.

In an example, the threshold current is a pulsed current. A rising edge and a falling edge of a pulse of the threshold current are equal or approximately equal to a rising edge and a falling edge of a pulse of the video signal current. Contrary to the threshold current, the bias current has no pulses or has only long lasting pulses.

According to a further embodiment of the laser circuit, a duration of a pulse of the threshold current is equal or longer than a duration of the pulse of the video signal current.

According to a further embodiment of the laser circuit, the video digital-to-analog converter comprises a first number N of series circuits. A series circuit of the first number N of series circuits comprises a converter switch and a current regulator. The current regulator is realized e.g. as a single current source or a single current sink. For example, each series circuit of the first number N of series circuits comprises a converter switch and a current regulator.

According to a further embodiment of the laser circuit, the bias digital-to-analog converter comprises a second number P of series circuits. A series circuit of the second number P of series circuits comprises a converter switch and a current regulator. The current regulator is realized e.g. as a single current source or a single current sink. For example, each series circuit of the second number P of series circuits comprises a converter switch and a current regulator.

According to a further embodiment, the laser circuit includes a gain digital-to-analog converter having an output coupled to a control input of the video digital-to-analog converter.

The gain digital-to-analog converter is configured e.g. to scale the video signal current.

According to a further embodiment, the laser circuit comprises a further video digital-to-analog converter, a further bias digital-to-analog converter and a further laser with a first and a second terminal. The first terminal of the further laser is coupled to the further video digital-to-analog converter and to the further bias digital-to-analog converter. The further video digital-to-analog converter is configured to provide a further video signal current having a pulse form. The further bias digital-to-analog converter is configured to provide a further bias current. A value of the further bias current is smaller than a further laser threshold value of the further laser. A further laser current comprises the further video signal current and the further bias current. In case of a pulse of the further video signal current, the further laser current is higher than the further laser threshold value. Thus, the laser circuit includes two channels.

According to a further embodiment, the laser circuit comprises an additional video digital-to-analog converter, an additional bias digital-to-analog converter and an additional laser with a first and a second terminal. The first terminal of the additional laser is coupled to the additional video digital-to-analog converter and to the additional bias digital-to-analog converter. The additional video digital-to-analog converter is configured to provide an additional video signal current having a pulse form. The additional bias digital-to-analog converter is configured to provide an additional bias current. A value of the additional bias current is smaller than an additional laser threshold value of the additional laser. An additional laser current comprises the additional video signal current and the additional bias current. In case of a pulse of the additional video signal current, the additional laser current is higher than the additional laser threshold value. Thus, the laser circuit includes three channels. For example, the laser is a red laser, the further laser is a green laser and the additional laser is a blue laser. The three channels are constructed in an equal manner.

According to an embodiment, a method for operating a laser circuit comprises:
- providing a video signal current by a video digital-to-analog converter,
- providing a bias current by a bias digital-to-analog converter, and
- emitting radiation by a laser.

A laser current flows through the laser and comprises the video signal current and the bias current. A value of the bias current is smaller than a laser threshold value of the laser. The video signal current has a pulse form. In case of a pulse of the video signal current, the laser current is higher than the laser threshold value.

In an example, the video digital-to-analog converter has smaller steps than the bias digital-to-analog converter and has a wider current range than a current range over the laser threshold value. The current range over the laser threshold value is a desired or predetermined current range. By using the video digital-to-analog converter, the system has a high granularity of steps around the current threshold. This granularity corresponds to current steps above the threshold. The first step of light can be precisely controlled, once the threshold current value varies with laser temperature. The video digital-to-analog converter has small steps to precisely reach the laser threshold value and precisely control the current above the laser threshold value and therefore precisely control the amount of light. The lower step bias digital-to-analog converter brings an advantage that fine current steps below the laser threshold value are not required, only in a close proximity of the laser threshold value which can be provided by the video digital-to-analog converter.

According to a further embodiment, a laser circuit comprises a temperature sensor, a temperature compensating circuit having an input coupled to the temperature sensor, a video digital-to-analog converter and a laser with a first and a second terminal. The first terminal of the laser is coupled to the temperature compensating circuit and to the video digital-to-analog converter.

Advantageously, the influence of temperature on the optical power of the laser can be reduced. The effort for realization of the temperature compensating circuit may be lower than to amend a control signal provided to the video digital-to-analog converter.

According to a further embodiment of the laser circuit, the temperature compensating circuit is implemented as a temperature controlled digital-to-analog converter.

According to a further embodiment, the laser circuit comprises a digital circuit with an input coupled to the temperature sensor and an output coupled to a control input of the temperature compensating circuit.

According to a further embodiment of the laser circuit, the digital circuit increases a compensating current which flows through the temperature compensating circuit with increasing temperature measured by the temperature sensor.

According to a further embodiment of the laser circuit, the temperature sensor is realized as one of a group consisting of a silicon bandgap temperature sensor, thermocouple, resistance thermometer and thermistor.

According to a further embodiment of the laser circuit, the laser circuit includes a bias digital-to-analog converter that is coupled to the first terminal of the laser.

According to a further embodiment of the laser circuit, the laser circuit includes a threshold digital-to-analog converter that is coupled to the first terminal of the laser.

According to a further embodiment of the laser circuit, the laser circuit includes a gain digital-to-analog converter having an output coupled to an input of the video digital-to-analog converter.

According to a further embodiment of the laser circuit, the laser circuit includes a video current mirror. The output of the gain digital-to-analog converter is coupled via the video current mirror to the input of the video digital-to-analog converter.

According to a further embodiment, the laser circuit comprises a switch with a first and a second terminal and a control terminal. The first terminal of the switch is coupled to the temperature compensating circuit and the video digital-to-analog converter. The second terminal of the switch is coupled to the first terminal of the laser.

According to a further embodiment, the laser circuit includes a bias current mirror and a bias digital-to-analog converter. The bias digital-to-analog converter is coupled via the bias current mirror to a node between the second terminal of the switch and the first terminal of the laser.

According to a further embodiment, the laser circuit includes a threshold current mirror and a threshold digital-to-analog converter. The threshold digital-to-analog converter is coupled via the threshold current mirror to the first terminal of the switch.

According to a further embodiment, the laser circuit comprises a further video digital-to-analog converter, a further temperature compensating circuit and a further laser with a first and a second terminal. The first terminal of the further laser is coupled to the further temperature compensating circuit and to the further video digital-to-analog converter.

According to a further embodiment, the laser circuit comprises an additional video digital-to-analog converter, an additional temperature compensating circuit and an additional laser with a first and a second terminal. The first terminal of the additional laser is coupled to the additional temperature compensating circuit and to the additional video digital-to-analog converter. The three temperature compensating circuits are connected e.g. to outputs of the digital circuit. In an example, one temperature sensor is sufficient for temperature measurement.

According to an embodiment, a method for operating a laser circuit comprises:
- measuring a temperature by a temperature sensor,
- providing a signal that depends on the temperature to a temperature compensating circuit,
- providing a compensating current by the temperature compensating circuit,
- providing a video signal current by a video digital-to-analog converter, and
- emitting radiation by a laser. The compensating current and the video signal current flow through the laser.

According to a further embodiment, a laser circuit comprises a switched-capacitor circuit, a video digital-to-analog converter and a laser with a first and a second terminal. The first terminal of the laser is coupled to the switched-capacitor circuit and to the video digital-to-analog converter.

Advantageously, the switched-capacitor circuit is able to provide a charge package at a predetermined point of time. Thus, a laser current can be increased at the predetermined point of time. The charge package can be adjusted by controlling the switched-capacitor circuit.

According to a further embodiment of the laser circuit, the switched-capacitor circuit comprises a capacitor and a first switch that is coupled to a first electrode of the capacitor and is coupled to the first terminal of the laser. Thus, the first switch is arranged e.g. between the first electrode of the capacitor and the first terminal of the laser.

Advantageously, the charge package can be adjusted by selecting a capacitance value of the capacitor and by selecting an input voltage for charging the capacitor.

According to a further embodiment of the laser circuit, the switched-capacitor circuit comprises a circuit node, a number R of capacitors and the first switch. A first electrode of a capacitor of the number R of capacitors is coupled to the circuit node. The first switch that is coupled to the circuit node and is coupled to the first terminal of the laser. The number R may be one or larger than one.

According to a further embodiment of the laser circuit, the number R is one. The switched-capacitor circuit comprises a control digital-to-analog converter having an output which is coupled to the circuit node.

According to a further embodiment of the laser circuit, the number R is one. A second electrode of a capacitor of the number R of capacitors is connected to a reference potential terminal or to an output of a buffer of the switched-capacitor circuit.

According to an alternative embodiment of the laser circuit, the number R is larger than one. The switched-capacitor circuit comprises a decoder having a number R of decoder outputs. A decoder output of the number R of decoder outputs is coupled to a second electrode of a capacitor of the number R of capacitors. Thus, each decoder output is coupled to a second electrode of a corresponding capacitor.

According to a further embodiment of the laser circuit, the switched-capacitor circuit comprises a number R of buffers. A buffer of the number R of buffers couples a decoder output of the number R of decoder outputs to a second electrode of a capacitor of the number R of capacitors. Thus, each decoder output is coupled via a buffer to a second electrode of a corresponding capacitor.

According to a further embodiment of the laser circuit, the switched-capacitor circuit comprises a diode which is coupled to the first switch and to the first terminal of the laser or is coupled to the circuit node and to the first switch.

According to a further embodiment of the laser circuit, the switched-capacitor circuit comprises a diode which is coupled to the first switch and to the first terminal of the laser or is coupled to the circuit node and to the first switch. For example, the diode is arranged between the first switch and the first terminal of the laser or between the first electrode of the capacitor and the first switch. Both arrangements fulfill the function to allow a current flow only in one direction. The diode is optional.

According to a further embodiment of the laser circuit, the switched-capacitor circuit comprises a second switch. The second switch has a first terminal coupled to the circuit node. For example, a second terminal of the second switch is coupled to the output of the control digital-to-analog converter. For example, the second switch is arranged between the output of the control digital-to-analog converter and the first electrode of the capacitor.

According to a further embodiment of the laser circuit, the second switch comprises a first transistor with a first controlled path and a first control terminal and a second transistor with a second controlled path and a second control terminal. The first controlled path and the second controlled path are connected in series. A node is coupled to the second control terminal and to the first control terminal. For example, the second control terminal is connected to the first control terminal.

According to a further embodiment of the laser circuit, the switched-capacitor circuit comprises a voltage buffer. An output of the voltage buffer is coupled to the second terminal of the second switch. For example, an input of the voltage buffer is coupled to the output of the control digital-to-analog converter or to an output of a reference voltage source. In an example, the voltage buffer is arranged between the output of the control digital-to-analog converter or of the reference voltage source and the second switch.

According to a further embodiment of the laser circuit, the switched-capacitor circuit comprises a discharging switch which is coupled to the first terminal of the laser and to the second terminal of the laser. The discharging switch is arranged e.g. between the first and the second terminal of the laser. In an example, the discharging switch couples the first terminal of the laser to a second electrode of the capacitor and/or to a reference potential terminal.

According to a further embodiment of the laser circuit, the second switch and the discharging switch are in a conducting state during the same duration. They are simultaneously in a conducting state. Furthermore, they are simultaneously in a non-conducting state.

According to a further embodiment of the laser circuit, the laser circuit includes a threshold digital-to-analog converter that is coupled to the first terminal of the laser.

According to a further embodiment of the laser circuit, the laser circuit includes a bias digital-to-analog converter that is coupled to the first terminal of the laser.

According to a further embodiment, the laser circuit comprises a further video digital-to-analog converter, a further switched-capacitor circuit and a further laser with a first and a second terminal. The first terminal of the further laser is coupled to the further switched-capacitor circuit and to the further video digital-to-analog converter. In an example, the laser and the further laser emit radiation in different ranges.

According to a further embodiment, the laser circuit comprises an additional video digital-to-analog converter, an additional switched-capacitor circuit and an additional laser with a first and a second terminal. The first terminal of the additional laser is coupled to the additional switched-capacitor circuit and to the additional video digital-to-analog converter. In an example, the laser, the further laser and the additional laser emit radiation in different ranges, such as e.g. in the red range, green range and blue range. Thus, the laser circuit is e.g. a red-green-blue laser circuit, abbreviated RGB laser circuit.

According to an embodiment, a method for operating a laser circuit comprises:
- providing a charge package by a switched-capacitor circuit,
- providing a video signal current by a video digital-to-analog converter, and
- emitting radiation by a laser as a function of the video signal current and the charge package.

According to a further embodiment, the method comprises providing a threshold current by a threshold digital-to-analog converter and emitting radiation by the laser in addition as a function of the threshold current.

According to a further embodiment, the method comprises providing a bias current by a bias digital-to-analog converter and emitting radiation by the laser in addition as a function of the bias current.

According to an embodiment, an arrangement comprises the laser circuit. The arrangement is realized as one of a group comprising head mounted display, head up display, AR wearable device, pico-projector, laser projection system, LIDAR, AR glasses, mixed reality glasses and VR glasses. AR is the abbreviation for augmented reality. VR is the abbreviation for virtual reality. LIDAR is the abbreviation for light detection and ranging.

The laser circuits and the arrangements described above are particularly suitable for the method for operating a laser circuit. Features described in connection with the laser circuits or the arrangements can therefore be used for the method and vice versa.

The following description of figures of examples or embodiments may further illustrate and explain aspects of the laser circuit and the method for operating a laser circuit. Arrangements, devices and circuit blocks with the same structure and the same effect, respectively, appear with equivalent reference symbols. In so far as arrangements, devices and circuit blocks correspond to one another in terms of their function in different figures, the description thereof is not repeated for each of the following figures.
Figures 1A to 1C show exemplary embodiments of a laser circuit;
Figures 2A to 2D show further exemplary embodiments of a laser circuit;
Figures 3A to 3D show another exemplary embodiment of a laser circuit;
Figures 4A to 4E show additional exemplary embodiments of a laser circuit;
Figures 5A to 5I show additional exemplary embodiments of a laser circuit;
Figure 6 shows an exemplary embodiment of an arrangement with a laser circuit.

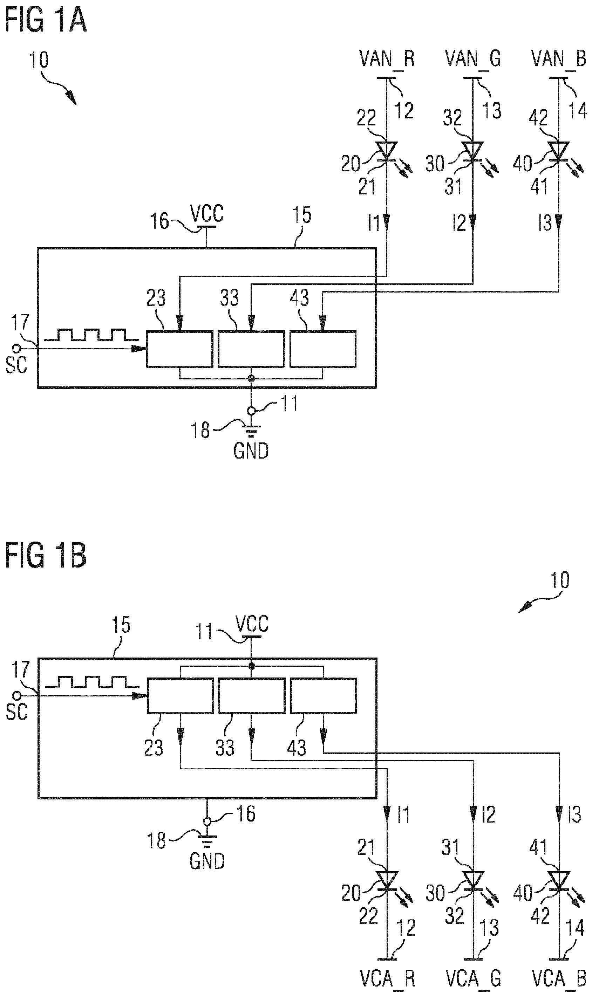

Figure 1A shows an exemplary embodiment of a laser circuit 10 which includes a laser 20 with a first and a second terminal 21, 22 and a video digital-to-analog converter 23, abbreviated video DAC. Moreover, the laser circuit 10 includes a first supply terminal 11 and a second supply terminal 12. The first supply terminal 11 is connected to the video DAC 23. The video DAC 23 is connected to the first terminal 21 of the laser 20. The second terminal 22 of the laser 20 is connected to the second supply terminal 12. Thus, a series circuit of the laser 20 and of the video DAC 23 couples the second supply terminal 12 to the first supply terminal 11. In the example shown in Figure 1A, the first supply terminal 11 is connected to a reference potential terminal 18. The video DAC 23 includes a control input. The video DAC 23 is configured as current sink. The video DAC 23 includes metal oxide semiconductor field-effect-transistors, abbreviated MOSFETs. The video DAC 23 comprises n-channel MOSFETs. The first terminal 21 of the laser 20 is a cathode of the laser 20. The second terminal 22 of the laser 20 is an anode of the laser 20.

Additionally, the laser circuit 10 comprises a further laser 30 having a first and a second terminal 31, 32 and a further video digital-to-analog converter 33, abbreviated further video DAC 33. The laser circuit 10 includes a further supply terminal 13. The further supply terminal 13 is coupled via a series circuit of the further laser 30 and the further video DAC 33 to the first supply terminal 11.

Similarly, the laser circuit 10 comprises an additional laser 40 with a first and a second terminal 41, 42 and an additional video digital-to-analog converter 43, abbreviated additional video DAC. The laser circuit 10 includes an additional supply terminal 14. The additional supply terminal 14 is coupled via a series circuit of the additional laser 40 and of the additional DAC 43 to the first supply terminal 11.

The laser circuit 10 includes an integrated circuit 15. The integrated circuit 15 is realized as an output stage. The integrated circuit 15 includes a semiconductor body. The integrated circuit 15 implements a driver integrated circuit. The video DAC 23, the further video DAC 33 and the additional video DAC 43 are integrated on the semiconductor body of the integrated circuit 15. The laser circuit 10 includes a third supply terminal 16. The third supply terminal 16 and the first supply terminal 11 are both connected to the integrated circuit 15. The integrated circuit 15 includes a control input 17. The control input 17 is coupled to control inputs of the three video DACs 23, 33, 43. The control input 17 is realized as a bus input.

A ground potential GND is provided at the first supply terminal 11. The word "provided" can be replaced by the word "tapped" and vice versa. A supply voltage VAN_R is provided to the second supply terminal 12. The supply voltage VAN_R is positive with respect to the ground potential GND. A further supply voltage VAN_G is provided at the further supply terminal 13 (e.g. VAN_G > GND). An additional supply voltage VAN_B is provided to the additional supply terminal 14 (e.g. VAN_B > GND). A supply voltage VCC is tapped at the third supply terminal 16 (e.g. VCC > GND). A laser current I1 flows through the laser 20. A further laser current I2 flows through the further laser 30. An additional laser current I3 flows through the additional laser 40.

A control signal SC is provided to the control input 17. The control signal SC is e.g. an input signal of the integrated circuit 15. For example, the control signal SC includes a series of pulses. The control signal SC or a signal derived from the control signal SC is provided to the three video DACs 23, 33, 43. The video DAC 23 controls a video signal current IVS which flows through the video DAC 23. The video signal current IVS flows from the second supply terminal 12 via the laser 20 and the video DAC 23 to the first supply terminal 11. Thus, in this example, the laser current I1 is equal to the video signal current IVS. Similarly, the control signal SC controls a further video signal current that flows through the further video DAC 33. Correspondingly, the control signal SC controls an additional video signal current that flows through the additional video DAC 43.

The laser 20 emits radiation that is electromagnetic radiation. For example, the laser 20 is configured to emit light e.g. in the red range. The additional laser 30 is configured to emit light e.g. in the green range. The additional laser 40 is configured to emit light e.g. in the blue range.

Figure 1B shows a further exemplary embodiment of a laser circuit 10 which is a further development of the embodiment shown in Figure 1A. In Figure 1B, the video DAC 23 is configured as a current source. The video DAC 23 includes p-channel MOSFETs. Similarly, the further video DAC 33 and the additional video DAC 43 are implemented as current sources. The first terminal 21 of the laser 20 is the anode of the laser 20. The second terminal 22 of the laser 20 is the cathode of the laser 20. As shown in Figure 1B, the supply voltage VCC can be tapped at the first supply terminal 11. A supply voltage VCA_R is provided to the second supply terminal 12. A further supply voltage VCA_G is applied to the further supply terminal 13. An additional supply voltage VCA_B is applied to the additional supply terminal 14. The third supply terminal 16 is connected to the reference potential terminal 18. The reference potential GND can be tapped as at the third supply terminal 16. As shown in Figure 1B, the laser current I1 flows from the first supply terminal 11 via the video DAC 23 and the laser 20 to the second supply terminal 12.

The supply voltage VCA_R is negative with respect to the supply voltage VCC. Moreover, the supply voltage VCA_R is negative with respect to the ground potential GND. Correspondingly, the further and the additional supply voltages VCA_G, VCA_B are negative with respect to the supply voltage VCC. Moreover, the further and the additional supply voltages VCA_G, VCA_B are negative with respect to the ground potential GND. In an example, the supply voltage VCA_R, the further supply voltage VCA_G and the additional supply voltage VCA_B have three different values.

In an alternative, not shown embodiment, the supply voltage VCA_R, the further supply voltage VCA_G and the additional supply voltage VCA_B have identical values. In this case, the further supply terminal 13 and the additional supply terminal 14 are directly connected to the second supply terminal 12.

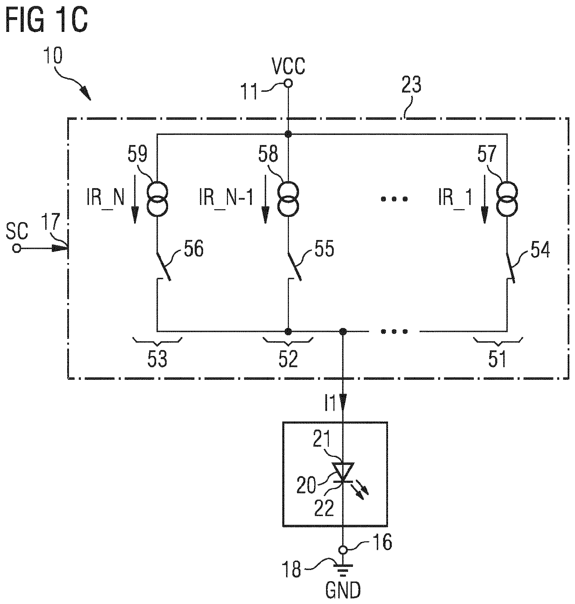

Figure 1C shows details of a laser circuit 10 which is a further development of the embodiments shown in Figures 1A and 1B. The video DAC 23 comprises a first number N of series circuits 51 to 53. In the example shown in Figure 1C, the first number N is 3. Alternatively, the first number N is e.g. 2, 4 or 8. Alternatively, the first number N is e.g. larger than 1, larger than 4 or larger than 7. A series circuit 51 of the first number N of series circuits 51 to 53 includes a converter switch 54 and a current regulator 57. The converter switch 54 and the current regulator 57 form the series circuit 51. Each of the series circuits 51 to 53 is connected on one side to the first supply terminal 11 and on the other side to the first terminal 21 of the laser 20. Thus, the video DAC 23 includes a first number N of current regulators 57 to 59.

Each of the first number N of current regulators 57 to 59 provides a constant current IR_1, IR_N-1, IR_N. In an example each of the first number N of current regulators 57 to 59 provide an identical current. Thus, the video DAC 23 is a thermometer-coded DAC. The control signal SC or a signal derived from the control signal SC controls the first number N of converter switches 54 to 56. The control signal SC includes a digital code for controlling the converter switches 54 to 56. In case a converter switch of the first number N of converter switches 57 to 59 is set in a conducting state, the corresponding current regulator of the first number N of current regulators 57 to 59 contributes to the laser current I1 that flows through the laser 20. The current regulator of the first number N of current regulators 57 to 59 is implemented as single current source.

Alternatively, the video DAC 23 is implemented as binary-weighted DAC or as segmented DAC.

Alternatively, the current regulator of the first number N of current regulators 57 to 59 is implemented as single current sink (e.g. in the video DAC 23 shown in Figure 1A).

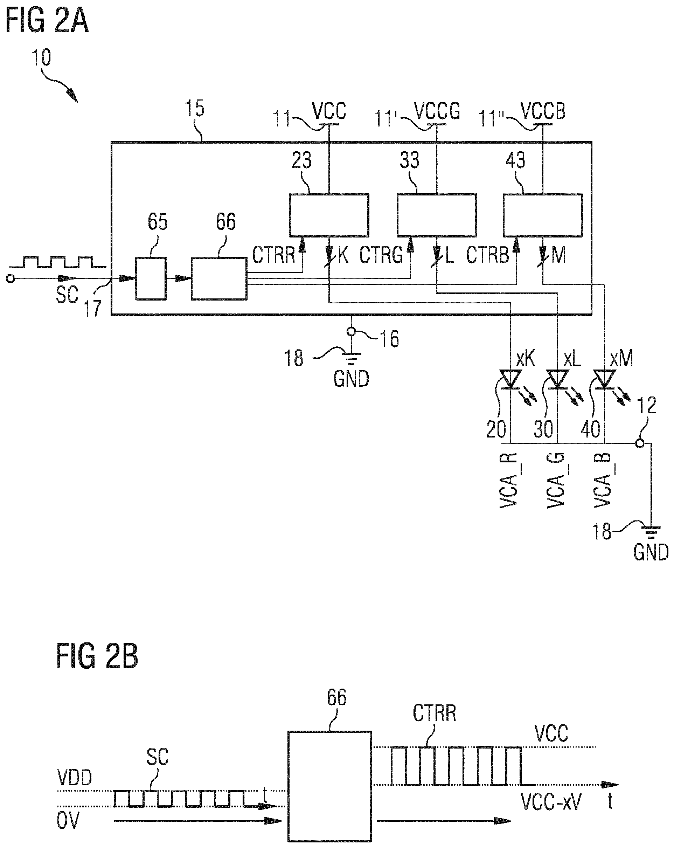

Figure 2A shows a further exemplary embodiment of a laser circuit 10 which is a further development of the embodiments shown in Figures 1A to 1C. The laser circuit 10 implements a high-side laser driving scheme with common cathode that is connected to the reference potential terminal 18. The laser circuit 10 includes a digital circuit 65 having an input connected to the control input 17. An output of the digital circuit 65 is coupled to the control input of the video DAC 23. Additionally, the digital circuit 65 is coupled via its output to a control input of the further video DAC 33 and to a control input of the additional video DAC 43. As shown in Figure 2A, the laser circuit 10 includes a level shifter 66 that is connected on its input side to the output of the digital circuit. On its output side the level shifter 66 is connected to the control input of the video DAC 23. Moreover, the level shifter 66 is connected on its output side to the control inputs of the further and the additional video DAC 33, 43. In an example, the converter switches 54 to 56 of the video DACs 23, 33, 43 are realized using p-channel MOSFETs. In the example shown in Figure 2A, the supply voltage VCC is provided to the first supply terminal 11. A further supply voltage VCCG is applied to a further first supply terminal 11'. An additional supply voltage VCCB is applied to the additional first supply terminal 11''. The first supply terminal 11, the further first supply terminal 11' and the additional first supply terminal 11'' are not connected to each other. The supply voltage VCC, the further supply voltage VCCG and the additional supply voltage VCCB have three different values.

The supply voltage VCA_R is provided at the second supply terminal 12. The second supply terminal 12 is connected to the reference potential terminal 18. Thus, the supply voltage VCA_R is equal to the ground potential GND. The third supply terminal 16 is connected to the reference potential terminal 18.

Thus, the voltage across the series circuit formed by the video DAC 23 and the laser 20 is equal to the supply voltage VCC. In order to drive the laser 20, a value for the supply voltage VCC is selected which is typically higher than a typical supply voltage of an integrated circuit.

In Figure 2B, a level shifter 66 with power domains of the input signal (VDD) and the output signal (VCC) is shown. The control signal SC includes input digital signals (such as shown on the left side of Figure 2B). The control signal SC is a digital signal having two values, namely the value 0 V corresponding to the reference potential GND and the value of a supply voltage VDD. A control voltage CTRR is provided by the level shifter 66. The control voltage CTRR has values between the supply voltage VCC and VCC-xV. Thus, the level shifter 66 is configured to convert the control signal SC into control signals CTRR which are suitable for controlling the converter switches 54 to 56 of the video DAC 23.

In the example shown in Figure 2A, the laser circuit 10 comprises a number K of lasers 20. Each of the number K of lasers 20 emit radiation in the red range. Thus, the laser circuit includes a number K of video DAC 23. The number K of video DAC 23 form a series circuit with the number K of lasers 20.

Similarly, the laser circuit 10 comprises a number L of further lasers 30. Each of the number L of further lasers 30 emit radiation in the green range. Thus, the laser circuit 10 includes a number L of further video DAC 33. The number L of further video DAC 33 form a series circuit with the number L of further lasers 30.

Correspondingly, the laser circuit 10 comprises a number M of additional lasers 40. Each of the number M of additional lasers 40 emit radiation in the blue range. Thus, the laser circuit 10 includes a number M of additional video DAC 43. The number M of additional video DAC 43 form a series circuit with the number M of additional lasers 40.

In the high-side laser driving scheme shown in Figures 2A and 2B, the current flow is as follows: the current is drawn from the first supply terminal 11 (called power supply), flows through the video DAC 23 (realizing a current source), exits the integrated circuit 15 (named laser driver) and enters the anode of the laser 20. In order to reduce the power consumption of such a system, the power supply should be separately adjusted for each laser color: red, green and blue (VCC, VCCG, VCCB respectively at Figure 2A). In such scheme, the cathodes of all lasers 20, 30, 40 are connected together (VCA_R, VCA_G, VCA_B) and most commonly connected to the ground potential GND. For such a laser circuit 10, the control signals CTRR, CTRG, CTRB at the input side of the video DACs 23, 33, 43 - being directly related to the video data (input) - are compatible with a given power supply domain (VCC, VCCG, VCCB respectively).

The laser circuit 10 as shown in Figure 2A is configured to drive the number K of red emitting lasers 20, the number L of green emitting laser 30 and the number M of blue emitting lasers 40. The laser circuit 10 composed of K-red channels, L-green channels and M-blue channels, with N-bit video data resolution per channels, leads to K x L x M x N separate control lines or double of it, if the signals are differential. Each signal needs to be level shifted from the digital domain (e.g. the digital circuit 65 in Fig. 2A) to a respective red, green or blue channel domain (VCC, VCCG, VCCB), resulting in a high number of level shifter circuits inside the level shifter 66, possibly multi stages level shifters, if voltage difference between the power domains is high. This increases a complexity and power consumption of the laser circuit 10, especially since the signal transitions occur at a high rate.

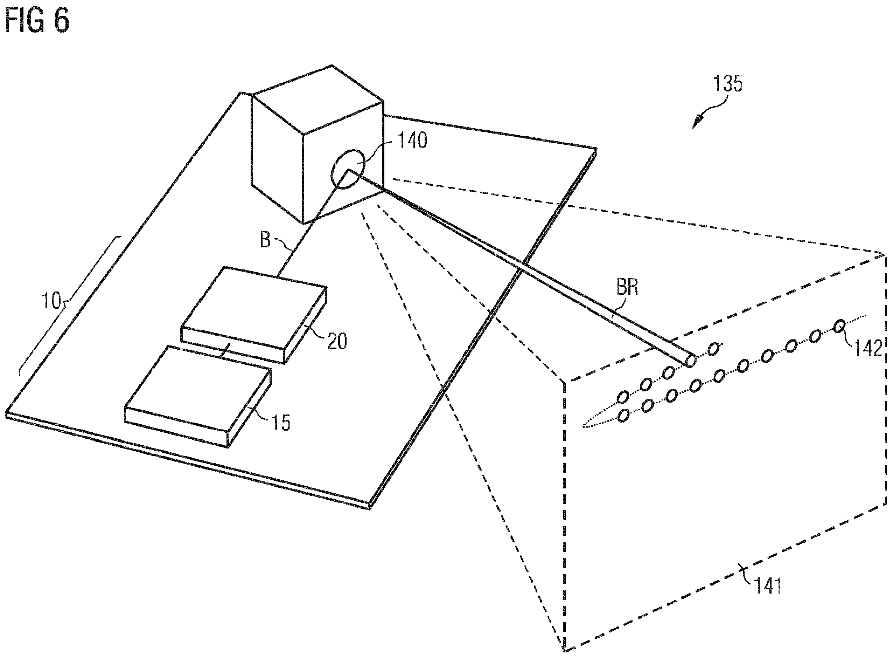

Laser beam scanning projectors rely on a set of RGB sources and MEMS mirrors, either a pair of mirrors which are swinging along on axis or a MEMS mirror which swings along two axis to create an image (such as shown in Figure 6). The RGB laser sources create a single pixel of the display which is then scanned in a 2d pattern to form an image. In such systems the lasers 20, 30, 40 are driven by current pulses, which duration and amplitude define the energy of the optical pulse at the laser output. The amount of energy per pulse per red, green and blue color is defined by the video data that define a content of the image, i.e. color definition of each pixel in the image. The video data of a certain bit depth per laser color is the input information to the laser circuit 10. The laser circuit 10 itself translates the video data information into appropriate current pulses fed to the lasers 20, 30, 40 further producing light pulses.

Taking into account a high resolution, high frame-rate and high color-depth display system, the laser circuit 10 is configured to handle high amount of video data at high repetition rate. The video data are received to the laser circuit 10 by a high speed digital interface resulting in video data sampling and further treatment by the digital circuit 65 of the laser circuit 10. In the design of the integrated circuit 15, the power supply voltage VDD of an integrated circuit gets lower with the more advanced technology nodes. On the other hand a forward voltage of the lasers (especially for the blue and green colors) is general much higher than a digital-domain power-supply-voltage VDD. Therefore, a high number of level shifter circuits and high repetition rate of signal transitions occurring at each level shifter circuit lead to an increase in power consumption of the laser circuit 10.

Since lasers 20, 30, 40 are driven by analog signals adjusted to the forward voltage of the lasers 20, 30, 40, one or more stages of the high speed level shifter 66 are implemented to carry the low swing digital video data to a higher voltage power domain (see Fig. 2B), where the output current pulses are generated. Therefore, a high number of level shifter circuits operating at high repetition rate are implemented in the laser circuit 10, introducing:
- an increase in power consumption of the laser circuit 10,
- complexity of designing high speed level shifter circuits adjusted to a number of power supply domains (for red, green and blue lasers, as each laser has its own range of the forward voltage), and
- unwanted propagation delay and pulse width jitter which causes an error in optical pulse energy impacting a color quality and white balance performance of the image.

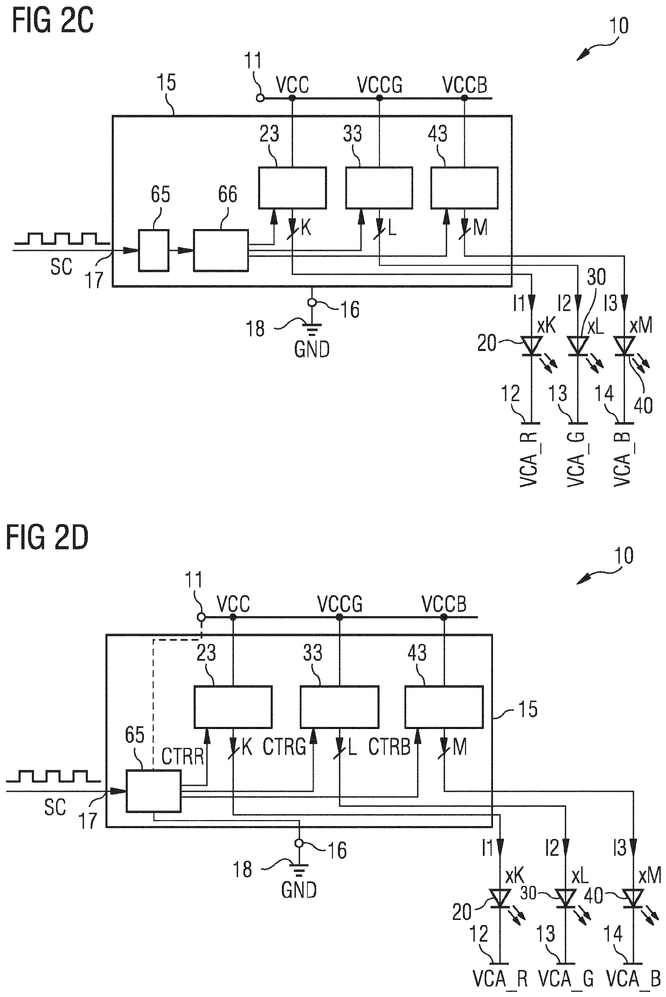

This challenge can be simplified if the cathode of the lasers 20, 30, 40 is connected to a negative potential as explained in Figures 2C and 2D.

Figure 2C shows a further example of a laser circuit 10 which is a further development of the embodiments shown above. In Figure 2C, a low power laser driver supply scheme for a high-side drive system is elucidated. The laser circuit 10 includes cathodes of the lasers 20, 30, 40 biased with a negative voltage. The second supply terminal 12 is not connected to the reference potential terminal 18. The supply voltage VCA_R tapped at the second supply terminal 12 is a negative voltage with respect to the ground potential GND. Similarly, the further and the additional supply voltages VCA_G, VCA_B tapped at the further and the additional supply terminals 13, 14 are negative voltages with respect to the ground potential GND.

The voltage which is applied to the series circuit of the video DAC 23 and of the laser 20 is equal to VCC - VCA_R. Since VCA_R has a value less than 0, a value of the supply voltage VCC can be reduced. Thus, the level shifter 66 can be realized with a smaller or more effective circuit in comparison to the level shifter used for the configuration shown in Figure 2A. The first supply terminal 11, the further first supply terminal 11' and the additional first supply terminal 11" are connected to each other. The supply voltage VCC, the further supply voltage VCCG and the additional supply voltage VCCB have one identical value.

In an alternative embodiment, as shown in Figure 2A, the first supply terminal 11, the further first supply terminal 11' and the additional first supply terminal 11'' are not connected to each other. The supply voltage VCC, the further supply voltage VCCG and the additional supply voltage VCCB have three different values.

In an alternative embodiment, not shown, exactly two of the terminals including the first supply terminal 11, the further first supply terminal 11' and the additional first supply terminal 11" are connected to each other. The supply voltage VCC, the further supply voltage VCCG and the additional supply voltage VCCB have two different values.

Figure 2D shows a further exemplary embodiment of a laser circuit 10 which is a further development of the above-shown embodiments. In Fig. 2D, a laser circuit 10 with cathodes biased with a negative voltage is elucidated. No level shifter or level shifters are used. The supply voltage VCA_R which is tapped at the second supply terminal 12 has a negative value with respect to the ground potential GND. The supply voltage VCC tapped at the first supply terminal 11 is equal to a typical supply voltage of an integrated circuit such as the integrated circuit 15. Thus, a value of the supply voltage VCC is in a range between 0.8 V and 5 V, alternatively between 2 V and 3.5 V. The value depends e.g. on the technology for fabrication of the integrated circuit 15. Thus, the laser circuit is free from a level shifter 66. The laser circuit 10 includes a digital circuit 65 that is directly connected to the control input of the video DAC 23. Similarly, the digital circuit 65 is directly connected to the control inputs of the further and the additional video DAC 33, 43.

The laser circuit 10 is free from a level shifter coupling an output of the digital circuit 65 to the control input of the video DAC 23. Advantageously, delays caused by the level shifter as shown in Figures 2A to 2C can be avoided. The power consumption inside of the integrated circuit 15 is reduced. The laser circuit 10 includes e.g. a power converter - not shown - that is realized as a DC to DC converter. The power converter is coupled on its output side to the second supply terminal 12. The power converter generates the supply voltage VCA_R. Similarly, the power converter generates the further and the additional supply voltages VCA_G, VCA_B. The three supply voltages VCA_R, VCA_G, VCA_B may have an equal value or may have two or three different values.

In an example, the digital circuit 65 is connected to the first supply terminal 11 by a connection line for supply of the digital circuit 65. The connection line (shown as a dashed line) is optional. The digital circuit 65 is connected to the third supply terminal 16. Thus, a voltage difference between the first supply voltage VCC and the ground potential GND is appropriate for the supply of the digital circuit 65, e.g. without a voltage down converter.

Advantageously, the low power supply scheme for the high side laser driver allows to significantly reduce the power consumption, signal propagation delay and pulse jitter in the high speed laser driver application. The laser circuit 10 is e.g. realized as common cathode laser driver.

Laser beam scanning projectors can offer significant advantages in terms of form factor as well as high brightness displays with limited power consumption. However, in the high side drive scheme, in order to minimize the power supply for a given laser, the power supply of a driving circuit at the laser circuit 10 should be separately adjusted per laser or per laser color or per similar supply voltage. In many cases the forward voltage of a laser is much higher than the power supply domain of the high speed input data interface. For this reason the video data signals need to travel through two or more power supply domains. The signals cross between the power supply domains by level shifters that adjust properly input signal voltage levels into appropriate output signal voltage levels. This can be avoided by setting the second supply terminal 12 at a negative voltage value.

The laser circuit 10 of Figure 2D realizes a system powering scheme in which laser cathodes are powered at the negative power supply domain in order to reduce the supply voltage of the laser driving channel. In this solution the voltage level shifting ratio and thus the power consumption at the level shifters are reduced. In the case the laser cathode can be set low enough, the level shifters are not needed at the laser driver at all, as depicted in Figure 2D.

In the laser circuit 10, the power supply voltages at the integrated circuit 15 are partially or fully connected (Fig. 2C and 2D shows VCC, VCCG, VCCB connected all together) and the laser cathodes are fully or partially split and biased at a proper potential including negative values. This solution offers sufficient voltage room for the lasers 20, 30, 40 to operate properly - a forward voltage between the laser cathode and anode is ensured by an adequate adjustment of a cathode supply level, including the negative voltage values. The cathode voltage adjustments should leave sufficient headroom voltage for proper operation of the current source in the integrated circuit 15.

By merging some or all power supply domain levels at the driver (VCC, VCCG, VCCB), a part or all of the control signals share the same power domain (in Fig. 2D all types of control signals CTRR, CTRG, CTRB are at the same power domain). This common domain can be chosen such that the system requires:
- Less of a level shifting; the VCC/VCCG/VCCB supply voltage is closer to the supply of the digital circuit 65, where the level shifter design is simpler and less power hungry (Fig. 2C); or
- No level shifters, if VCC/VCCG/VCCB supply voltage is at the same level as the supply of the digital circuit 65. Then the cathode voltage supply VCA_R, VCA_G, VCA_B needs to be further lowered, to allow a correct operation of current sources and lasers 20, 30, 40, saving the power consumption, reducing the design complexity and design size as well as a signal propagation delay and pulse width jitter.

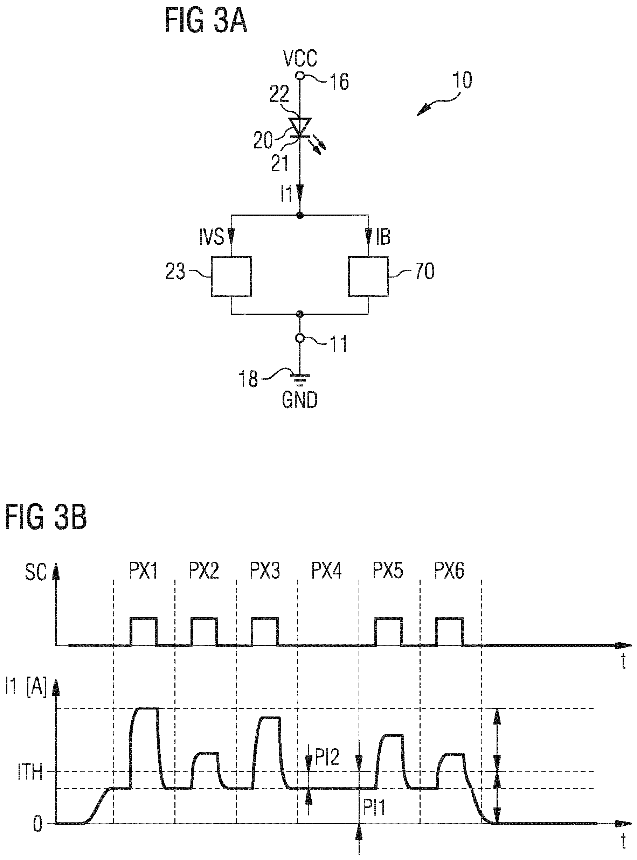

Figure 3A shows an exemplary embodiment of a laser circuit 10 which is a further development of the embodiments shown above. The laser circuit 10 comprises a bias digital-to-analog converter 70, abbreviated bias DAC. The bias DAC 70 can be named pre-bias DAC. The bias DAC 70 is connected parallel to the video DAC 23. Thus, the bias DAC 70 couples the first terminal 21 of the laser 20 to the first supply terminal 11. A laser current I1 flowing through the laser 20 is the sum of the currents flowing through the video DAC 23 and the bias DAC 70. The bias DAC 70 provides the bias current IB. The laser current I1 can be calculated using the equation: $I 1 = IVS + IB ,$ wherein IVS is the video signal current and IB is the bias current. Correspondingly, the laser circuit 10 includes a further bias DAC (not shown) coupled to the first terminal 31 of the further laser 30. The laser circuit 10 comprises an additional bias DAC (not shown) coupled to the first terminal 41 of the additional laser 40. The further and the additional bias DAC are configured and connected corresponding to the bias DAC 70.

Figure 3B shows an exemplary embodiment of signals of the laser circuit 10 shown in Figure 3A as a function of a time t. In the first line, a control signal SC for one converter switch 54 to 56 of the video DAC 23 for a first to a sixth period PX1 to PX6 is shown. The control signal SC implements an on trigger for a current pulse. The second line shows the laser current I1 as a function of time t. A pulse in the control signal SC results in a pulse of the laser current I1. Before the first period PX1, the bias current IB rises from the value 0 A to a value above 0 A. The bias current IB is constant during the six periods PX1 to PX6. After the last period PX6 with a pulse, the bias current IB is reduced to the value 0 A.

The bias current IB is set such that the bias current IB has a value below a laser threshold value ITH of the laser 20. The laser threshold value ITH can be named laser threshold current value or laser threshold current. The laser 20 emits radiation when the laser current I1 is higher than the laser threshold value ITH. The laser 20 does not emit radiation when the laser current I1 is lower than the laser threshold value ITH. Thus, the laser 20 does not emit radiation in case only the bias current IB is flowing through the laser 20. The video DAC 23 generates pulses.

In an example, the bias DAC 70 is configured such that the bias DAC 70 is able to generate the bias current IB with values in a range between 0 A and 100% of the laser threshold value ITH. Thus, the bias DAC 70 is able to generate the bias current IB with 100 % or 95% or 90% of the laser threshold value ITH. The laser threshold value ITH is equal to the sum of a first and a second part PI1, PI2. Thus, ITH = PI1 + PI2, wherein PI1 is a DC part being equal to the bias current IB and PI2 is a return-to-zero part (abbreviated RTZ part).

Thus, the bias DAC 70 generates the bias current IB that comprises the first part PI1 which is constant during the periods and with the second part PI2 which has a pulse form. A pulse of the second part PI2 and a pulse of the video signal current IVS both rise at a first point of time and fall at a second point of time.

In Figure 3B only the control signal SC for one converter switch 54 is shown. The height of the pulses of the laser current I1 depend on the control signal SC of the converter switch 54 and also from the control signals - not shown - of the further converter switches 55, 56. Thus, different heights of the laser current I1 are achieved by controlling the number of converter switches 54 to 56 by a number of control signals SC. Only current above the laser threshold value ITH is converted into radiation. The video DAC 23 realizes an n Bit resolution. The control signals SC of the converter switches 54 to 57 are free from a pulse during one of the periods PX1 to PX6 (in the example shown in Figure 3A, there are no pulses during the fourth period PX4). During this period, no radiation is emitted by the laser 20. Thus, the laser 20 is black during this period PX4.

In Figure 3B, the output currents of two current sources, namely the bias DAC 70 and the video DAC, are combined. The amplitude of the bias DAC 70 provides the laser current I1 up to the laser threshold value ITH, wherein the video DAC 23 provides current pulses that are converted into light (optical energy of each pulse depends on the video data content of each pixel). The bias DAC 70 can be programmed in terms of:
- Total output current amplitude to reach the laser threshold value ITH (see Fig. 3B).
- RTZ part amplitude (a portion of the ITH current - see Fig. 3B) that is modulated in synchronization with the video DAC 23.

The bias DAC 70 is composed of a number of current source cells that depending on the input digital code are turned ON or OFF providing total output current proportional to the digital input code. The DAC cells are controlled not only by the input digital code but also by the current pulse ON trigger that makes predetermined DAC cells to modulate in synchronization with the video DAC 23. The laser circuit 10 controls how many cells of the bias DAC 70 are controlled by the current pulse trigger (RTZ part) and how many are excluded from this trigger (DC part). The cells that are OFF due to the input digital code provide no current to the laser 20.

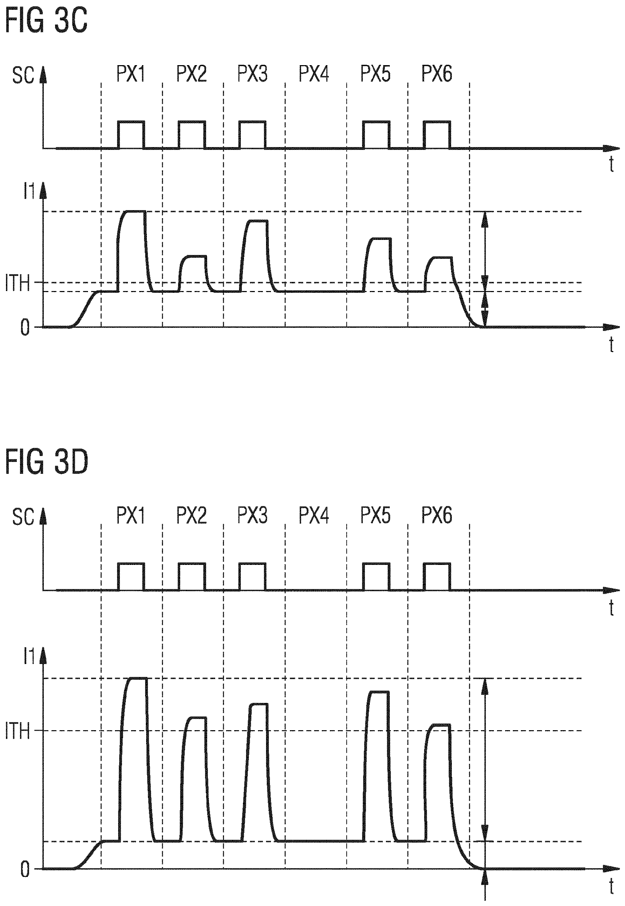

Figure 3C shows an alternative embodiment of signals of the laser circuit 10 shown in Figure 3A as a function of the time t. According to Figure 3C, the bias current IB has a value close to the laser threshold value ITH. In an example, the bias current IB is in a range between 60% and 100%, alternatively in a range between 75% and 100% or alternatively in a range between 80% and 95% of the laser threshold value ITH. Advantageously, the video DAC 23 sets only a small number of converter switches 54 to 56 into a conducting state in order to increase the laser current I1 above the laser threshold value ITH. Thus, most of the series circuits of the first number of series circuit 51 to 53 of the video DAC 23 can be used to set different values of the laser current I1 above the laser threshold value ITH and thus different values of radiation emitted by the laser 20. Consequently, an optical resolution of the laser circuit 10 is increased. However, since the value of the bias current IB is higher in the configuration shown in Figure 3C in comparison to the configuration shown in Figure 3B, the laser circuit 10 may have an increased power consumption.

Figure 3D shows an alternative embodiment of signals of the laser circuit 10 shown in Figure 3A as a function of time t. The value of the bias current IB is e.g. in a range between 5% and 30% of the laser threshold value ITH. The laser circuit 10 as shown in Figure 3D has e.g. the following advantages: Low power consumption due to minimized DC current flowing through the laser 20, benefit on laser spectral broadening reducing so called coherence artifacts due to low value of DC current that pre-biases the lasers during a pulsed operation, and high contrast e.g. in a laser-based display system. The high contrast is obtained by a low laser bias current IB during the black pixels content of the displayed image as well as a precise control of current pulse that corresponds to a lowest brightness optical pulse (least significant step of the optical pulse). The laser circuit 10 performs a laser modulation.

The laser circuit 10 as shown in Figure 3D combines output currents of two current sources: The bias DAC 70 and the video DAC 23. The bias DAC amplitude provides the bias current IB well below the laser threshold value ITH and provides a DC current only. The video DAC 23 provides current pulses that are converted into light with N-bit resolution. The additional DAC input codes (related to M bits) and extended DAC range is used for precise control of a current under the laser threshold value ITH. The advantage of this solution is the precision of reaching the laser threshold value ITH that is comparable with the smallest current step that defines the optical pulse amplitude resolution. In this way a black pixel corresponds to low DC bias current; black is really black, not influenced by a spontaneous laser emission that can be visible at a laser bias close to the threshold. At the same time the smallest step of light pulse (deltaP) is comparable with the first step of light pulse, which may not be the case if in alternative solutions the bias DAC 70 brings the laser 20 slightly above the laser threshold, generating already multiples of delta P. Then the contrast performance would be worsen (e.g. as explained above using Figure 3C).

In an example, both concepts can be implemented by combining them and thus achieving full programmability on the amount of laser current I1 fed to the laser 20 at any point of system operation.

The laser circuit 10 is configured to switch OFF or minimize the current fed to the lasers 20, 30, 40, once the laser circuit 10 does not display light pulses (black pixels, train of black pixels, MEMS fly-back time) as shown in Fig. 3B, 3C and 3D.

The laser circuit 10 is used e.g. in a single or multiple laser driving system, like RGB and multiples of any of the lasers, laser arrays etc. (see Fig. 1A and 1B). In such systems the video DAC 23 and the bias DAC 70 are part of the bigger current sink/current source block providing total current to the laser anode/cathode, depending on a laser driving scheme (high side and low side drive).

In the most common driving scheme of laser beam scanning projectors, the lasers 20, 30, 40 are driven by current pulses combined with a DC biasing current. A high value of DC biasing current, comparable with the laser threshold value ITH, combined with a modulation current that is directly translated into the optical pulses (current over the laser threshold) composes an advantageous way of driving the lasers 20, 30, 40 in the laser beam scanning system. The solution shown in Figure 3C results in an increased power consumption, as during the modulation current OFF time, the DC bias current IB is high, consuming electrical power while the laser circuit 10 should not produce any optical power to the display. In addition such scheme does not allow to modulate the lasers 20, 30, 40 to a very low bias current IB, well below the laser threshold value ITH, to achieve spectral broadening of the lasers 20, 30, 40, that is needed for avoiding coherence artifacts on the displayed image.

In case the bias current IB has a high value, advantageously a high modulation speed of the laser 20 can be achieved. Depending on a possible system specification, this example is advantageous for a high speed system.

An alternative solution as shown in Figure 3D is to lower the DC bias current and increase the modulation current amplitude (current that is converted into the light). In this solution, part of the modulation current falls below the laser threshold, therefore the resolution of intensity of a given pixel is reduced.

The laser circuit 10 overcomes the technical tasks mentioned above by a concept of two (or multiple) current sources (or two or multiple current sinks) which output currents are combined together and provide an optimal laser operation in terms of power consumption, spectral broadening and a high contrast.

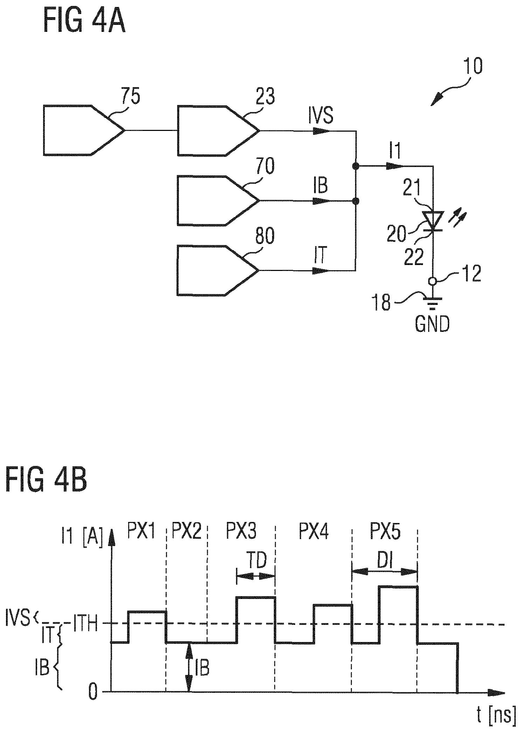

Figure 4A shows an exemplary embodiment of a laser circuit 10 which is a further development of the above-shown embodiments. The laser circuit 10 comprises the video DAC 23, the bias DAC 70 and a threshold digital-to-analog converter 80, abbreviated threshold DAC. The three DACs 23, 80, 70 are connected to the first terminal 21 of the laser 20. Moreover, the laser circuit 10 comprises a gain digital-to-analog converter 75, abbreviated gain DAC. The gain DAC 75 is connected on its output side to an input of the video DAC 23. In this example, the second supply terminal 12 that is coupled to the second terminal 22 of the laser 20 is connected to the reference potential terminal 18. Thus, the video DAC 23, the threshold DAC 80 and the bias DAC 70 are realized as current source circuits. The video DAC 23 generates the video signal current IVS. The bias DAC 70 generates the bias current IB. The threshold DAC 80 generates a threshold current IT. A laser current I1 is a sum of the currents provided by the video DAC 23, the threshold DAC 80 and the bias DAC 70. Thus, the laser current I1 can be calculated according to the following equation: $I 1 = IVS + IB + IT$

The height of the video signal current IVS provided by the video DAC 23 is a function of an output signal of the gain DAC 75.

In the example shown in Figure 4A, the laser circuit 10 includes a DAC for laser driving which comprises several DACs with a timing diagram for the DAC operation as shown in Fig. 4B. The laser 20 is driven pulse by pulse, and a duration TD of each pulse (pixel duration) is usually the same in operation. If the laser current I1 is below the laser threshold value ITH, there will be no optical power generated. The difference between the laser current I1 (which can be named total laser current) and the laser threshold value ITH will be almost proportional to the optical power generated. This difference is the net current. On the other hand, advantageously, a certain value of the laser current I1 is provided outside the pulse to make a better transient behavior when the next pulse is coming. Therefore, currents IVS, IB, IT from the three DACs 23, 70, 80 flow to the laser 20. The video DAC 70 is configured to control the optical power. The bias current IB continuously flows to the laser 20 and can be programmed. The bias DAC 70 can also be named DC bias DAC. The threshold DAC 80 is configured to adjust the threshold current IT for different lasers and/or different laser temperatures, as a laser threshold value ITH depends on a laser and its temperature. The threshold DAC 80 provides the threshold current IT which is the difference of the laser threshold value ITH and the bias current IB. The gain DAC 75 is used to adjust the LSB value of the video DAC 23, since different lasers 20, 30, 40 may require different ranges of video DAC output.

In an alternative, not shown embodiment, the video DAC 23, the threshold DAC 80 and the bias DAC 70 are realized as current sink circuits.

Figure 4B shows typical signals of the laser circuit 10 shown in Figure 4A as function of time t. In Figure 4B, an example of the timing diagram of a DAC for laser driving is illustrated. In Figure 4B, the laser current I1 is shown for five periods PX1 to PX5. The laser current I1 has a pulse form. The laser current I1 has the value of the bias current IB between the pulses. The value of the threshold current IT is selected such that the sum of the threshold current IT and of the bias current IB is equal or approximately equal to the laser threshold value ITH. Thus, IT + IB = ITH

The laser current I1 is equal to or is approximately the sum of the laser threshold value ITH and the video current ISV. The five periods PX1 to PX5 correspond to five pixels. A duration TD of a pulse can also be named pixel duration. Typically, the duration TD of the pulses is constant. A distance DI of the rising edges of two adjacent pulses is larger than the duration TD. The radiation emitted by the laser 20 during one of the periods PX1 to PX5 is a function of the video signal current IVS and the pixel duration TD. In Figure 4B, the laser current I1 is shown as an ideal driver current. Since the laser current I1 can obtain large values, the laser current I1 is a non-periodic analog signal with varying amplitudes. The threshold DAC 80 provides the threshold current IT only during the pixel duration TD. Also the video DAC 23 provides the video signal IVS only during the pixel duration TD. After the end of the last period PX5, the bias current IB is reduced to the value 0 A or approximately 0 A. Thus, the laser circuit 10 is configured to operate with a power down sequence after the last period PX5 with a pulse.

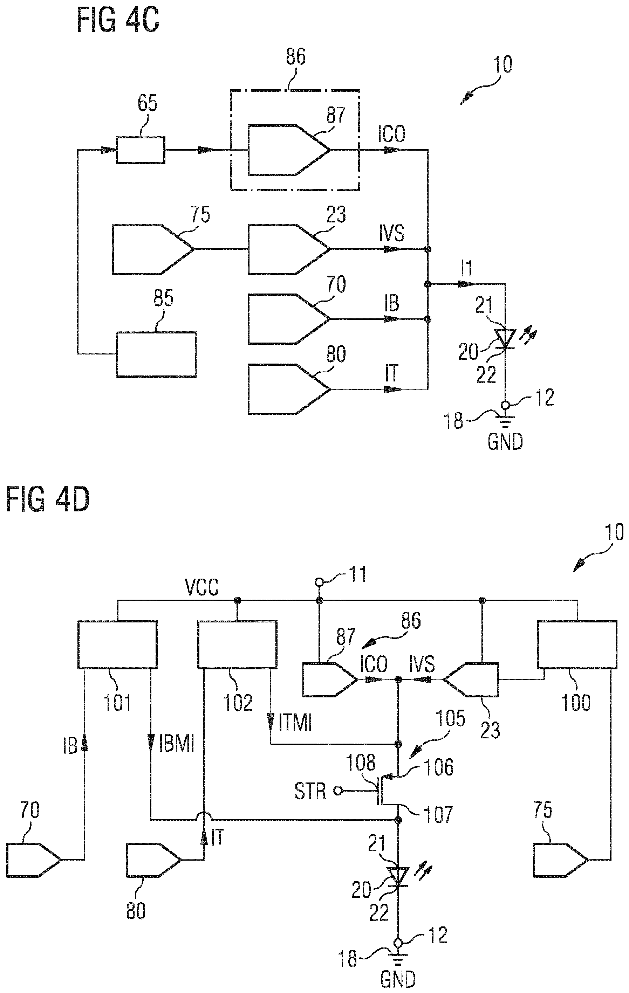

Figure 4C shows a further exemplary embodiment of a laser circuit 10 which is a further development of the embodiments shown above. In Figure 4C, the laser circuit 10 is configured for laser temperature compensation. The laser circuit 10 comprises a temperature sensor 85. The temperature sensor 85 is e.g. realized as laser temperature sensor. Moreover, the laser circuit 10 includes a temperature compensating circuit 86. The temperature compensating circuit 86 is implemented as a temperature controlled digital-to-analog converter 87, abbreviated TC DAC. The name of the TC DAC 87 results from the coupling of the TC DAC 87 to the temperature sensor 85. The temperature controlled digital-to-analog converter 87 can also be named other or further digital-to-analog converter. The TC DAC 87 is coupled to the first terminal 21 of the laser 20. Thus, the TC DAC 87 generates a compensating current ICO that contributes to the laser current I1. The laser current I1 can be calculated according to the following equation: $I 1 = IVS + IB + IT + ICO$

The digital circuit 65 has an input coupled to the temperature sensor 85. An output of the digital circuit 65 is coupled to an input of the temperature compensating circuit 86 and thus to an input of the TC DAC 87.

The temperature sensor 85 is arranged in close vicinity to the laser 20. The temperature sensor 85 measure the temperature of the laser 20. The compensating current ICO is set by the digital circuit 65 such that an influence of a temperature on the radiation emitted by the laser 20 is reduced. The compensating current ICO rises with rising temperature.

In a not shown embodiment, the laser circuit 10 includes the further laser 30 and the additional laser 40 which are shown for example in Figures 1A and 1B. The temperature sensor 85 measures the temperature in vicinity of the three lasers 20, 30, 40. The laser circuit 10 includes a further temperature compensating circuit and an additional temperature compensating circuit. The further temperature compensating circuit includes a further temperature controlled DAC. Similarly, the additional temperature compensating circuit includes an additional temperature controlled DAC. These DACs are structured and connected such as the TC DAC 87. The digital circuit 65 is coupled on its output side to the further and to the additional temperature compensating circuit.

In an example, the three lasers 20, 30, 40 are configured for emission of radiation in different ranges such as red, blue and green radiation. Thus, in an example the temperature characteristics of the three lasers 20, 30, 40 is different. Thus, the control signals provided by the digital circuit 65 to the three temperature compensating circuits 86 are set to reduce a temperature influence on the radiation emitted by the three lasers 20, 30, 40 individually.

The laser circuit 10 as shown in Fig. 4C includes a separate TC DAC 87 for temperature compensation. In this case, input code of the gain DAC 75 and the threshold DAC 80 only vary during the initial optical calibration and are not involved in laser temperature compensation. Based on the output of the laser temperature sensor 65 and the predetermined dependency of the optical power from the temperature, the code of the TC DAC 87 is calculated in digital circuit domain, namely by the digital circuit 65. As a result, laser temperature compensation is achieved with fast transient response. By this laser circuit 10, better dynamic linearity of the net laser current is achieved, resulting in better quality of a display.

In an alternative, not shown embodiment, the laser circuit 10 comprises a further temperature sensor. The further temperature sensor is located in vicinity to the further laser 30. An additional temperature sensor of the laser circuit 10 is located in vicinity to the additional laser 40. The three temperature sensors are coupled via the digital circuit 65 to the three temperature compensating circuits 86. Thus, the temperature compensation can be performed with high precision, because the temperature of the three lasers 20, 30, 40 is measured individually.

The laser circuit 10 of Figure 4C comprises a laser temperature compensation. In fact, the optical power with a certain laser current I1 is strongly dependent on the laser temperature, since the laser threshold value ITH as well as the gain from the net current to the optical power is temperature dependent. However, the laser current I1 is dynamic and varies in a high frequency up to 100 MHz. As a result, the laser temperature changes during the laser operation. This creates a temperature dependent optical power, and thus, impacts the quality of the display. By the use of the TC DAC 87, the optical power is nearly independent from temperature.

Based on the laser driver application, a system has information about the video code sequence before the video code is applied to the video signal DAC 23. On the other hand, the over temperature characterization of the optical power of the laser 20 is predetermined. By means of the temperature sensor 85, the code of the threshold DAC 80 and of the gain DAC 75 could be adjusted to create the correct driving current. However, changing gain DAC code means changing the LSB of the video DAC. This will create a slow transient response at video DAC output, since a huge parasitic capacitor inside the video DAC 23 is charged or discharged. The slow transient response deteriorates e.g. the dynamic linearity of the laser current I1, and thus, impacts the quality of the display. Thus, the use of the temperature sensor 85 and of the TC DAC 87 is advantageous in comparison to compensate the temperature influence by adjusting the gain DAC 75 and the threshold DAC 80.

Figure 4D shows an exemplary embodiment of a laser circuit 10 which is a further development of the embodiments shown above. The laser circuit 10 includes a video current mirror 100. The output of the gain DAC 75 is coupled via the video current mirror 100 to the video DAC 23. Moreover, the digital circuit 10 includes a bias current mirror 101. The output of the bias DAC 70 is coupled via the bias current mirror 101 to the first terminal 21 of the laser 20. Similarly, the laser circuit 10 comprises a threshold current mirror 102. An output of the threshold DAC 80 is coupled via the threshold current mirror 102 to the first terminal 21 of the laser 20. The TC DAC 87, the video DAC 23, the bias current mirror 101 and the threshold current mirror 102 are configured as current sources which provide current to the laser 20.

Additionally, the laser circuit 10 comprises a switch 105 with a first and a second terminal 106, 107 and a control terminal 108. The second terminal 107 of the switch 105 is connected to the first terminal 21 of the laser 20. The bias DAC 70 is coupled via the bias current mirror 101 to a node between the second terminal 107 of the switch 105 and the first terminal 21 of the laser 20. The threshold DAC 80 is coupled via the threshold current mirror 102 to the first terminal 106 of the switch 105. Also the output of the TC DAC 87 is connected to the first terminal 106 of the switch 105. Additionally, the output of the video DAC 23 is connected to the first terminal 106 of the switch 105. The switch 105 is realized as a MOSFET, such as a p-channel MOSFET or an n-channel MOSFET.

The TC DAC 87 and the video DAC 23 are implemented in high side for fast transient response, while the bias DAC 70, the threshold DAC 80 and the gain DAC 75 are implemented in low side, e.g. to reduce the number of level shifters. A p-channel MOS transistor is implemented as the global switch 105 for pulse control.

Thus, the bias current mirror 101 mirrors the bias current IB provided by the bias DAC 70. The mirrored current IBMI is provided to the laser 20 independently from the state of the switch 105. The currents provided by the threshold current mirror 102, the TC DAC 87 and the video DAC 23 are only applied to the laser 20, when the switch 105 is set in a conducting state.

In an alternative, not shown embodiment, the bias DAC 70 and/or the threshold DAC 80 are implemented in high side.

The TC DAC 87 may be implemented in high side or in low side. The video DAC 23 may be implemented in high side or in low side. The bias DAC 70 may be implemented in high side or in low side. The threshold DAC 80 may be implemented in high side or in low side. The gain DAC 75 may be implemented in high side or in low side.

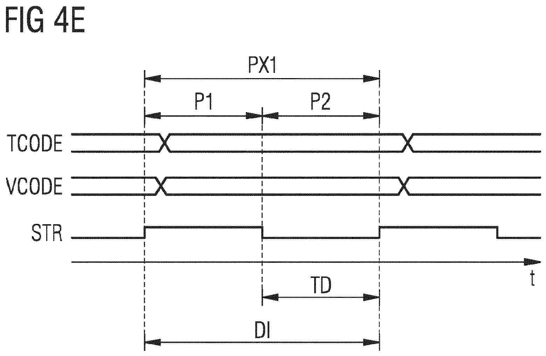

Figure 4E shows typical signals of the laser circuit 10 of Figure 4D. The first two lines symbolize the control signal TCODE provided to the TC DAC 87 (the control signal TCODE can be named temperature compensation DAC code) and the control signal VCODE provided to the video DAC 23 which can be named video DAC code VCODE. A control signal STR is provided to the control terminal 108 of the switch 105 and is shown in the third line. A low value of the control signal STR sets the switch 105 in a conducting state. The switch 105 is set in the conducting state during the pixel duration. The timing diagram of the operation is shown in Fig. 4E. To avoid the synchronicity issue, the video DAC code VCODE and the temperature compensation DAC code TCODE can only vary when the global switch 105 is off. As a result, when the pixel pulse is on, these two DACs 23, 87 are already settled with the updated code. All the DACs in the laser circuit 10 are implemented e.g. as current steering DAC.

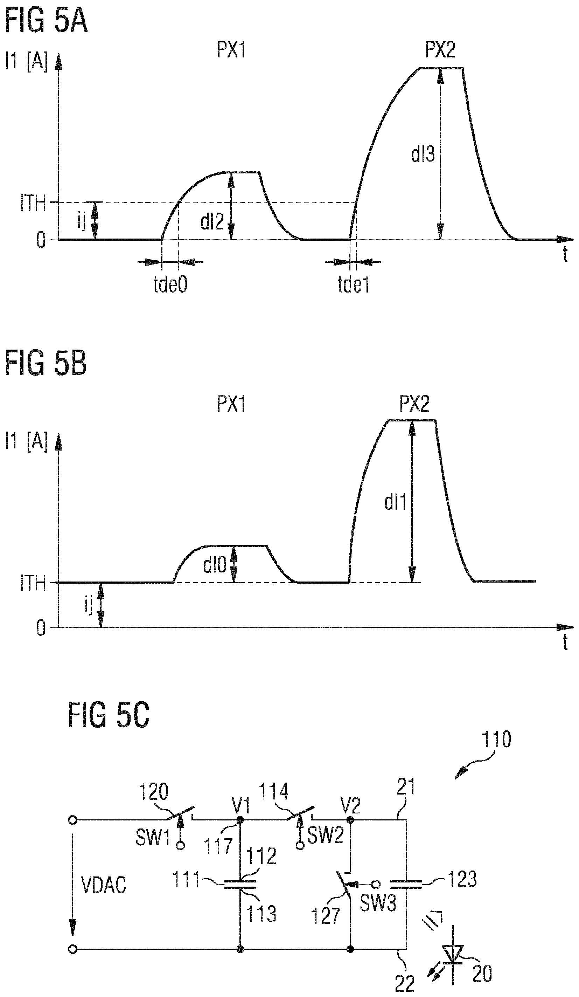

Figures 5A and 5B show typical signals of a laser circuit 10 e.g. shown in Figures 1A and 1B. The laser current I1 is shown as a function of the time t during a first and a second period PX1, PX2. As shown in Figure 5A, a pulse of the laser current I1 starts at the current value 0 A. Contrary to this, the pulse of the laser current I1 starts at the laser threshold value ITH in Figure 5B. The signals shown in Figure 5A are similar to the signals shown in Figure 3D, whereas the signals shown in Figure 5B are similar to the signals shown in Figure 3C.

As shown in Figure 5A, there is a delay time tde0 between the start of the pulse and the point of time at which the laser current I1 crosses the laser threshold value ITH. The delay time tde0 of a pulse with a low desired value of the laser current I1 is longer in comparison to a delay time tde1 of a pulse with a high desired value of the laser current I1. In period PX1, the radiation emission has a low brightness and in period PX2 the radiation emission has a high brightness. In Figure 5A, a laser control without pre-biasing is shown. When using simplest driving scheme (similar to Figures 1A and 1B), wherein current is applied only during periods where light supposed to be emitted, turn on delay phenomena will occur (related to the time needed to charge a junction capacitance Cj of the laser 20 by the laser current I1). Since lasing occurs only when the laser current I1 is above the laser threshold value ITH, for periods PX1 with small intensity, time to cross this threshold (tde0 on Fig. 5A) is much longer then for high intensity periods PX2 (tde1 on Fig. 5A). This causes additional change of light pulse duration which is perceived as brightness change. In an extreme case of very low brightness pulses, turn on delay can be longer than pulse duration TD and no light will be emitted. On the other hand in this driving scheme current step even for low brightness pulses is significant (dI2, dI3 on Fig. 5A) which helps with spectral broadening of laser spectrum.

Contrary to that as shown in Figure 5B, since the laser current I1 already starts at the value of the laser threshold value ITH, there is no delay time for reaching the laser threshold value ITH. In Figure 5B, a laser control with pre-biasing is shown. In order to reduce the turn on delay tde, a value of the bias current IB close to the laser threshold value ITH can be applied. Consequently, the delay time tde = ~0 for any pulse amplitude or brightness. For low brightness a pulse amplitude of current pulse is very small which causes that emitted light has a very narrow bandwidth (no spectral broadening effect).

Figure 5C shows an exemplary embodiment of a detail of a laser circuit 10 which is a further development of the embodiments shown above. A capacitive compensation of a laser threshold value ITH is shown. The laser circuit 10 implements a charge transfer. The laser circuit 10 comprises a switched-capacitor circuit 110 and the laser 20 with a first and a second terminal 21, 22. The laser 20 is shown as a laser capacitance 123. The laser capacitance 123 is a capacitance of the junction of the laser 20. The first and the second terminal 21, 22 of the laser 20 is coupled to the switched-capacitor circuit 110. The switched-capacitor circuit 110 comprises a capacitor 111 and a first switch 114 that is coupled to a first electrode 112 of the capacitor 111 and is coupled to the first terminal 21 of the laser 20. The switched-capacitor circuit 110 comprises a second switch 120 which couples an input of the switched-capacitor circuit 110 to the first electrode 112 of the capacitor 111. The switched-capacitor circuit 110 comprises a discharging switch 127 which is coupled to the first terminal 21 of the laser 20 and to the second terminal 22 of the laser 20. The switched-capacitor circuit 110 comprises a circuit node 117 that is connected to the first electrode 112 of the capacitor, the first switch 114 and the second switch 120. A first signal SW2 is provided to a control terminal of the first switch 114. A second signal SW1 is provided to a control terminal of the second switch 120. A third signal SW3 is provided to a control terminal of the discharging switch 127.

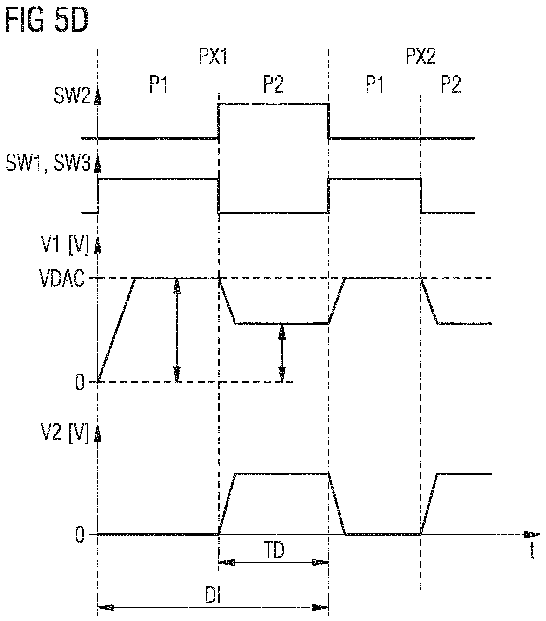

Figure 5D shows typical signals of the switched capacitor circuit 110 shown in Figure 5C. The laser 20 is represented only by the laser capacitance 123. In a first phase P1 of the period PX1, the first switch 114 is set in a non-conducting state by the first signal SW2 and the second switch 120 and the discharging switch 127 are set in a conducting state by the second and third signal SW1, SW3. A first voltage V1 is tapped at the first electrode 112 of the capacitor 111. The first voltage V1 is provided at the circuit node 117. A second voltage V2 is tapped at the first terminal of the laser 20. Thus, the capacitor 111 is charged resulting in a rising of the first voltage V1 up to an input voltage VDAC. The laser 20 is discharged; the second voltage V2 falls to 0 V or any other pre-defined voltage lower than previous value of the second voltage V2. In an example, the second voltage V2 falls to a value >0. A low value of one of the signals SW1, SW2, SW3 indicates that the corresponding switch 114, 120, 127 is set in a non-conducting state. A high value of one of the signals SW1, SW2, SW3 indicates that the corresponding switch 114, 120, 127 is set in a conducting state.

In a second phase P2 of the period PX1, the first switch 114 is set in a conducting state by the first signal SW2 and the second switch 120 and the discharging switch 127 are set in a non-conducting state the second and third signal SW1, SW3. Thus, the charge of the capacitor 111 is applied to the laser 20 resulting in a rising of the second voltage V2 and in a fall of the first voltage V1. The laser capacitance 123 is charged. The first and the second phase P1, P2 are periodically repeated. Each period PX1 to PX6 includes the first and the second phase P1, P2.

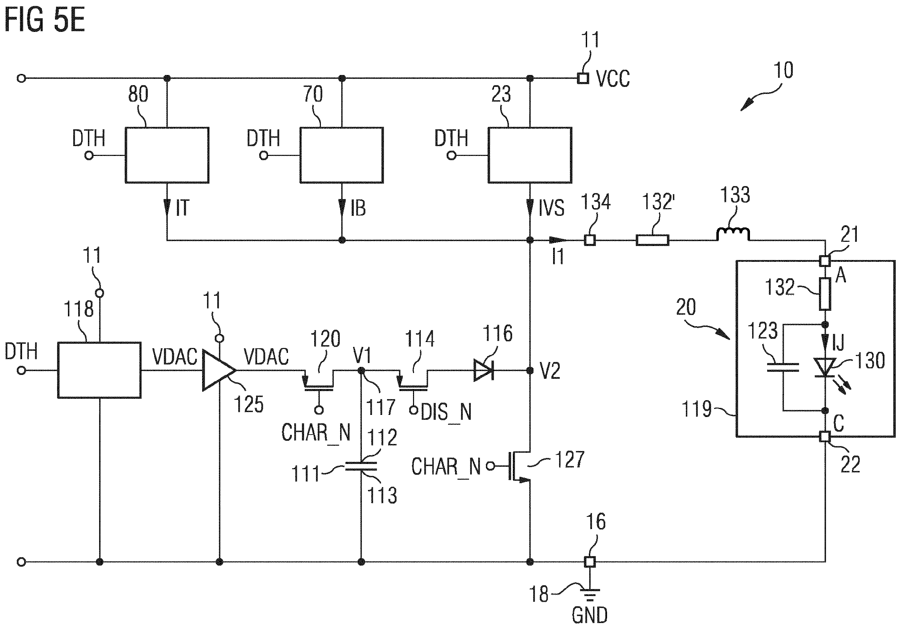

Figure 5E shows an exemplary embodiment of a laser circuit 10 which is a further development of the embodiments shown above. In Figure 5E, the laser 20 is shown in the form of an equivalent circuit 119. The equivalent circuit 119 of the laser 20 includes a laser diode 130 and the laser capacitance 123 which is arranged parallel to the laser diode 130. Moreover, the equivalent circuit 119 includes two resistances 132, 132' connected in series to the parallel circuit of the laser diode 130 and of the laser capacitance 123. Moreover, the equivalent circuit 119 includes an inductance 133 that is connected in series to the two resistances 132, 132'. Typically, the inductance 133 results from bonding wires for the connection of the laser 20 to the other parts of the laser circuit 10. The two resistances 132, 132' typically result from the resistances of the bonding wires, the bonding connections and the conducting paths of a semiconductor body which includes the laser 20. The laser capacitance 123 mainly results from the junction inside of the laser 20.

A second electrode 113 of the capacitor 111 is connected to the reference potential terminal 18. The switched-capacitor circuit 110 comprises a diode 116 which is coupled to the first switch 114 and to the first terminal 21 of the laser 20 or is coupled to the first electrode 112 of the capacitor 111 and to the first switch 114. The switched-capacitor circuit 110 comprises a control digital-to-analog converter 118, abbreviated control DAC. An output of the control DAC 118 is coupled to the first electrode 112 of the capacitor 111. The second switch 120 is arranged between the output of the control DAC 118 and the first electrode 112 of the capacitor 111. The switched-capacitor circuit 110 comprises a voltage buffer 125 which is coupled to the output of the control DAC 118 and to the second switch 120. Thus, the output of the control DAC 118 is coupled via the voltage buffer 125 and the second switch 120 to the first electrode 112 of the capacitor 111.

The control DAC 118 provides the input voltage VDAC at the output of the control DAC 118 as a function of a control signal DTH. Thus, the control DAC 118 converts a digital signal in a voltage. The digital signal DTH includes more than one bit. The video DAC 23, the bias DAC 70 and the threshold DAC 80 control the video signal current IVS, the bias current IB and the threshold current IT as a function of the control signal DTH. The video DAC 23, the bias DAC 70 and the threshold DAC 80 each converts a digital signal into a current. The first and the second switch 114, 120 and the discharging switch 127 are realized as transistors which are **e.g.** implemented as MOSFETs. A control voltage CHAR_N is provided to the control terminals of the second switch 120 and the discharging switch 127. A control voltage DIS_N is provided to the control terminal of the first switch 114. In an example, the three switches 114, 120 and 127 are realized as p-channel MOSFETs; thus, the control voltage CHAR_N has an inverted form with respect to the second and third signal SW1, SW3 and the control voltage DIS_N has an inverted form with respect to the first signal SW2.

The laser circuit 10 comprises the video DAC 23, optionally the bias DAC 70 and optionally the threshold DAC 80 which are coupled to the first terminal 21 of the laser 20.

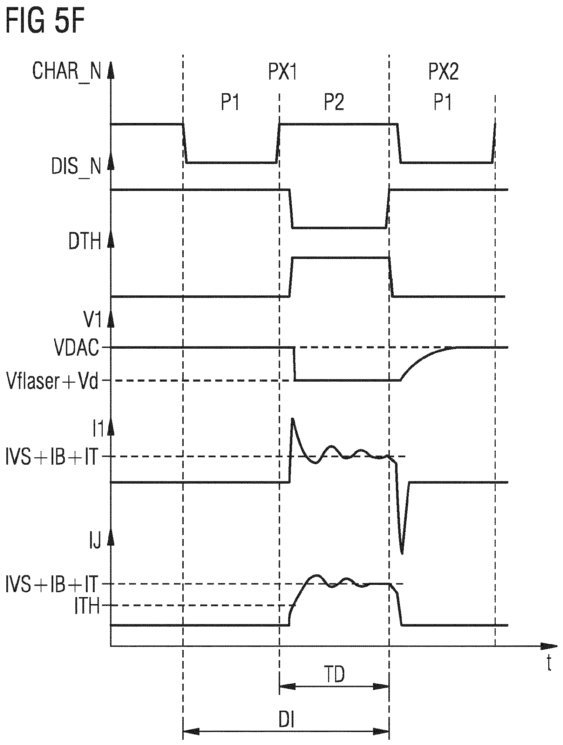

Figure 5F shows an exemplary embodiment of signals of the laser circuit 10 shown in Figure 5E. In Figure 5F, control voltages CHAR_N, DIS_N, the control signal DTH, the first voltage V1, the laser current I1 and a junction current IJ flowing through the laser diode 120 are shown as a function of the time **t.** The second switch 120 and the discharging switch 127 are set in a conducting state in the first phase P1 of the period PX1 and in non-conducting state in the second phase P2 of the period PX1 by the control voltage CHAR_N. The first switch 114 is set in a non-conducting state in the first phase P1 of the period PX1 and in the conducting state in the second phase P2 of the period PX1 by the control voltage DIS_N. There are non-overlapping time durations between the control voltages CHAR_N, DIS_N, **e.g.** to avoid any unwanted short circuits.

The distance DI is the duration of one period PX1. The distance DI is in a range from 1 ps to 100 ns, alternatively between 1 ps and 1 ns, alternatively between 1 ns and 10 ns or alternatively between 1 ns and 100 ns. The duration TD is a time when the laser current I1 is pulsed from the video DAC 23.

The laser current I1 has a peak after the start of the second phase P2 of the period PX1. The charge provided by the capacitor 112 is the origin of this peak. The peak results in an increased rise of the junction current IJ. Thus, the rising time of the pulse of the radiation is reduced.

The equivalent circuit 119 represents some properties of the laser 20 itself when driving the laser 20 in imaging applications:
- Turn on delay tde0, tde1 which is the time between applying the stimuli to the laser 20 and optical beam being produced. Main contributors to this effects are the laser capacitance 123 and the laser threshold value ITH.
- Narrow spectrum of laser light.
- Lasing threshold; the laser 20 goes into stimulated emission only if the junction current IJ is above the laser threshold value ITH (IJ > ITH).

In order to overcome shortcomings of driving schemes it is advantageous to combine steep current pulse charging of the laser capacitance 123 to the threshold current value ITH and pulse corresponding to ITH+dI. This can be achieved by capacitive charge transfer technique, wherein the charging time of the laser capacitance 123 is only limited by resistive (Rd+Rbond) and inductive (Lbond) parasitic elements as charge source (capacitor) current is practically unlimited.

The laser capacitance 123 is discharged to the ground potential GND or another known level below the threshold in order to guarantee initial conditions independent of a video current value. The diode 116 is used as a separation diode in order not to load the capacitor 111 with charge **e.g.** provided by the video DAC 23. The diode 116 is realized **e.g.** as a Schottky diode.

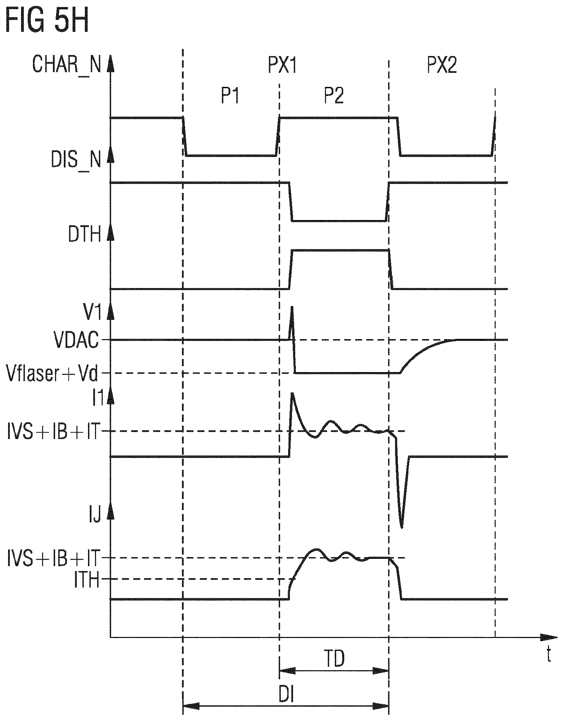

Advantageously, an amount of charge transferred is controlled by the DAC code DTH of the control DAC 118, **e.g.** in order to compensate laser threshold shift over temperature. The input voltage VDAC is generated at the output of the voltage buffer 125. The capacitor 111 has a capacitance value Ctrans and the laser capacitance 123 has a value Cj. For example, Ctrans >> Cj or the input voltage VDAC is very high (higher than the laser threshold value ITH). The voltage buffer 125 is able to charge even a large capacitor 111 within pulse OFF time as shown in Fig. 5F and 5H.

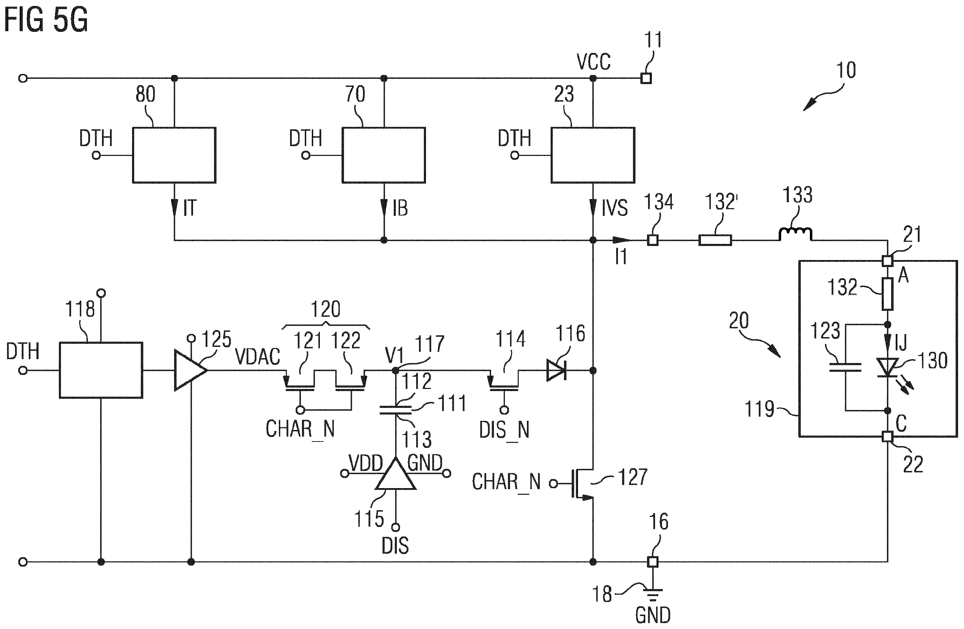

Figure 5G shows a further exemplary embodiment of a laser circuit 10 which is further development of the embodiments shown above, for example in Figures 5E and 5F. The switched-capacitor circuit 110 comprises a buffer 115 which is connected to the second electrode 113 of the capacitor 111. The second switch 120 comprises a first transistor 121 with a first controlled path and a first control terminal, and a second transistor 122 with a second controlled path and a second control terminal. The first controlled path and the second controlled path are connected in series. A node is coupled to the second control terminal and to the first control terminal. The first and the second transistor 121, 122 are **e.g.** realized as MOSFETs.

Figure 5H shows an exemplary embodiment of signals of the laser circuit 10 shown in Figure 5G. The laser circuit 10 realizes a capacitive compensation of a laser threshold. The laser circuit 10 realizes laser beam scanning, abbreviated LBS, pulse energy stability control and laser turn-on delay compensation. The laser circuit 10 is implemented as multichannel laser driver IC.

In order to achieve a correct white balance (color balance) of the displayed image of a laser beam scanning projector, the amount of light originating from red, green and blue lasers should be in a correct proportion between the listed colors and perform at the desired display brightness. For low brightness systems or dimmed operation modes, the light pulses need to be short and of a low amplitude above the laser threshold. The correct amount of energy in each pulse is critical in order to ensure a high image quality. At the same time, optical pulses originating from red, green and blue lasers need to be seen by the eye as overlapped, contributing to a particular pixel on the display. Unfortunately a turn-on delay of the laser can be longer then a duration of the pixel itself. The turn-on delay of the laser is strongly dependent on the laser itself (can vary with laser color) as well as on the driving scheme. In the most common driving scheme, the laser is driven by current pulses combined with a DC biasing current. The turn-on delay of the laser strongly depends on amount of biasing DC current value and modulation current amplitude and their relation to the laser threshold value ITH. The lower the DC biasing level, the longer the turn-on delay time is. At the same time a high DC bias current IB increases a power consumption of the system as well as reduces a spectral broadening capability of the system which are needed to reduce or eliminate coherence artifacts at the displayed image. The laser circuit 10 uses a laser driving scheme that allows to reduce the laser turn-on delay while keeping the DC bias current low.

In addition, if the laser 20 is not sufficiently discharged between displaying two consecutive pulses, optical pulse pile-up occurs, i.e. the energy of a given optical pulse is influenced by a previously displayed pulse. The laser circuit 10 implements a laser driving scheme that reduces or eliminates the optical pulses pile-up.

Another technical task in such systems is laser threshold shift with the laser temperature which strongly impacts the amount of energy contained in an optical pulse. The laser circuit 10 is realized as a programmable laser driving circuit which can be adjusted accordingly with the laser threshold shift in order provide precise control of the optical pulse energy at various laser temperature conditions and if laser ageing effects occur. The laser circuit 10 allows to overcome or diminish the effects listed above.

In order to provide a correct color and white balance of the displayed pixels at given brightness, one tracks and corrects for the temperature shifts at the red, green and blue lasers.

The laser circuit 10 is configured to provide a train of short optical pulses at a high repetition rate with the following performance that is advantageous especially for an image display system:
- Short turn-on delay of the laser.
- Low value of DC current that biases the laser 20 during a pulsed operation (low power consumption; benefit on laser spectral broadening reducing so called coherence artifacts).
- Short turn-off time of the laser 20 due to laser capacitance discharge to a low potential.
- Minimized or no pile-up effect on optical pulses.
- Advantages of Ctrans can be much smaller than in simple charge transfer architecture.
- Large dI/dt can be generated which helps spectral broadening of the laser light. Large output voltage helps to speed up current slope limited by bonding wire inductance.

The voltage at a pin 134 can go above VDD_HV during bootstrapping phase. Slew rate control might be advantageous. A system calibration is feasible: As mentioned before, the amount of charge transferred to the laser 20 can be easily controlled by the DAC code (Fig. 5E and 5G). The exact amount of charge being transferred to the laser 20 is calibrated in the system. On one side a sufficient amount of charge should be transferred to bring the laser biasing condition close to the lasing threshold. At the same time the amount of charge transferred should not introduce unwanted error in an optical pulse energy at the laser output. Too much of the charge transferred manifests itself as a positive offset in the optical pulse. Therefore, a full display system should be capable of performing an optical pulse calibration in order to keep the optical pulse energy well controlled while using the charge transfer laser driver architecture.

The amount of charge transfer can be set/calibrated such that it does not directly contribute to the optical pulse (the amount of charge is not sufficient to put the laser 20 in the light emitting state) or it introduces a controlled offset in the optical pulse if such function is beneficial for the system. In addition the laser threshold value ITH is influenced by a laser temperature shift and/or ageing effects in the laser 20. The laser driver architecture proposed can be adjusted accordingly with the laser threshold shifts (caused by any of the two effects mentioned above) ensuring high performance of the optical pulses in terms of: Short turn-on delay, short pulses with a high repetition rate, well controlled pulse energy and adjustable for various temperature/ageing condition of the laser 20.

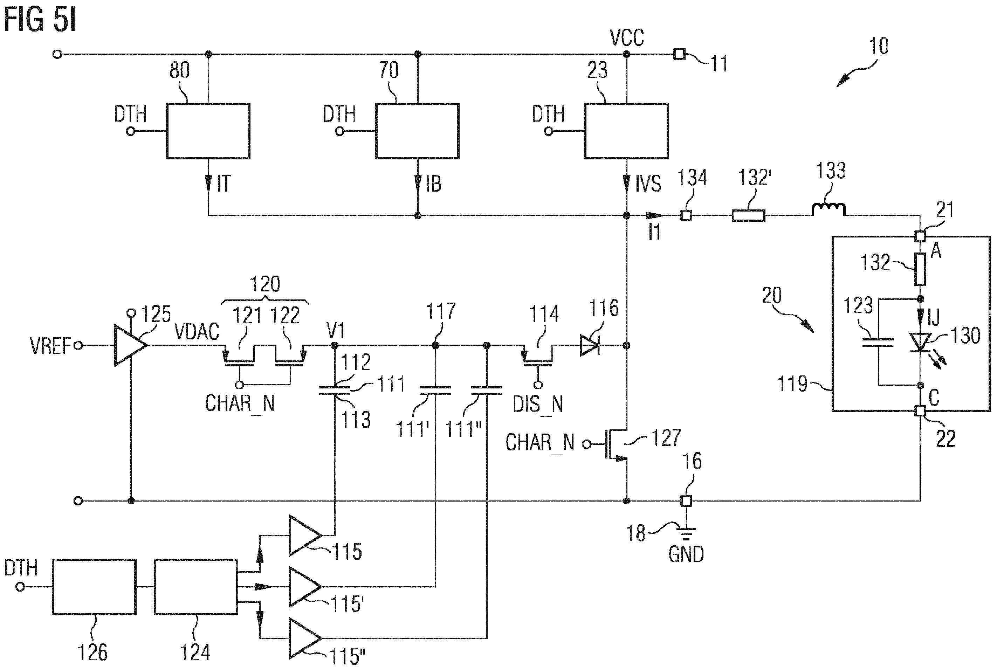

Figure 5I shows a further exemplary embodiment of a laser circuit 10 which is further development of the embodiments shown above. The switched-capacitor circuit 110 comprises a number R of capacitors 111, 111', 111". In the example shown in Figure 5I, the number R is three. Alternatively, the number R may be 2, 4 or 8. The number R may be larger than 1, larger than 2, larger than 3 or larger than 7. A first electrode 112 of a capacitor of the number R of capacitors 111, 111', 111'' is coupled to the circuit node 117. The first switch 114 is coupled to the circuit node 117 and is coupled to the first terminal 21 of the laser 20.

Moreover, the switched-capacitor circuit 110 comprises a decoder 124 having a number R of decoder outputs. A decoder output of the number R of decoder outputs is coupled to a second electrode 112 of a capacitor of the number R of capacitors 111, 111', 111". The switched-capacitor circuit 110 comprises a number R of buffers 115, 115', 115". A buffer of the number R of buffers 115, 115', 115'' couples a decoder output of the number R of decoder outputs to a second electrode 113 of a capacitor of the number R of capacitors 111, 111', 111". A buffer of the number R of buffers 115, 115', 115'' is supplied by the supply voltage VDD and the ground potential GND. The decoder 124 is controlled by the control signal DTH and generates a decoded control signal. A voltage which is either approximately the supply voltage VDD or is approximately the ground potential GND is provided at an output of a buffer of the number R of buffers 115, 115', 115", depending on the decoded control signal. Alternatively, the output of a buffer of the number R of buffers 115, 115', 115'' is in an open state or in a state in which a voltage is provided, depending on the decoded control signal. The voltage is e.g. approximately the ground potential GND or approximately the supply voltage VDD. Optionally, a level shifter 126 of the switched-capacitor circuit 110 is connected to an input of the decoder 124, if for example the control signal DTH is to be transferred from another power supply domain to the supply voltage VDD.

Figure 6 shows an exemplary embodiment of an arrangement 135 which comprises the laser circuit 10, a mirror 140 and a display 141. The laser circuit 10 includes the integrated circuit 15 (which is realized on a semiconductor body) and the laser 20 (which is realized on a further semiconductor body). The further semiconductor body comprises the laser 20 or more than one laser, for example the three lasers 20, 30, 40. The integrated circuit 15 comprises the analog and digital parts of the laser circuit 10 such as the video DAC 23, the bias DAC 70 and so on.

The laser 20 emits a radiation beam B that is reflected by the mirror 140. A reflected radiation beam BR provided from the mirror 140 hits the display 141. Since the radiation beam B is pulsed and the mirror 140 switches from one position to the next position, single pixels 142 are displayed on the display 141. The laser circuit 10 may be used e.g. for laser scanning based displays in AR/VR applications.

### Reference numerals

- 10: laser circuit
- 11, 11', 11": first supply terminal
- 12: second supply terminal
- 13: further supply terminal
- 14: additional supply terminal
- 15: integrated circuit
- 16: third supply terminal
- 17: control input
- 18: reference potential terminal
- 20: laser
- 21, 22: terminal
- 23: video digital-to-analog converter
- 30: further laser
- 31, 32: terminal
- 33: further video digital-to-analog converter
- 40: additional laser
- 41, 42: terminal
- 43: additional video digital-to-analog converter
- 51 to 53: series circuit
- 54 to 56: converter switch
- 57 to 59: current regulator
- 65: digital circuit
- 66: level shifter
- 70: bias digital-to-analog converter
- 75: gain digital-to-analog converter
- 80: threshold digital-to-analog converter
- 85: temperature sensor
- 86: temperature compensating circuit
- 87: temperature controlled digital-to-analog converter
- 100: video current mirror
- 101: bias current mirror
- 102: threshold current mirror
- 105: switch
- 106, 107: terminal
- 108: control terminal
- 110: switched capacitor circuit
- 111, 111', 111'': capacitor
- 112, 113: electrode
- 114: first switch
- 115, 115', 115": buffer
- 116: diode
- 117: circuit node
- 118: control digital-to-analog converter
- 119: equivalent circuit
- 120: second switch
- 121, 122: transistor
- 123: laser capacitance
- 124: decoder
- 125: voltage buffer
- 126: level shifter
- 127: discharging switch
- 130: laser diode
- 132, 132': resistance
- 133: inductance
- 134: pin
- 135: arrangement
- 140: mirror
- 141: display
- 142: pixel
- B: radiation beam
- BR: reflected radiation beam
- CHAR_N, DIS_N: control voltage
- GND: ground potential
- IB: bias current
- ICO: compensating current
- IT: threshold current
- ITH: laser threshold value
- IVS: video signal current
- IR_1 to IR_N: current
- I1, I2, I3: laser current
- PX1 to PX6: period
- P1, P2: phase
- PI1, PI2: part
- SW1, SW2, SW3: control signal
- t: time
- tde: delay time
- tde0, tde1: delay time
- TD: duration
- SC, STR: control signal
- VCC: first supply voltage
- VCCG, VCCB: supply voltage
- VAN_R, VAN_G: supply voltage
- VAN_B: supply voltage
- VCA_R: second supply voltage
- VCA_G, VCA_B: supply voltage
- VDAC: input voltage
- VDD: supply voltage
- VREF: reference voltage
- V1: first voltage
- V2: second voltage

## Claims

1. Laser circuit (10), comprising
- a video digital-to-analog converter (23),
- a laser (20) with a first and a second terminal (21, 22),
- a first supply terminal (11) which is coupled via the video digital-to-analog converter (23) to the first terminal (21) of the laser (20),
- a second supply terminal (12) which is coupled to the second terminal (22) of the laser (20),
wherein a first supply voltage (VCC) provided at the first supply terminal (11) is higher than a ground potential (GND) and
a second supply voltage (VCA_R) provided at the second supply terminal (12) is lower than the ground potential (GND), wherein the first terminal (21) of the laser (20) is an anode of the laser (20) and the second terminal (22) of the laser (20) is a cathode of the laser (20),
wherein the laser circuit (10) comprises a reference potential terminal (18),
wherein the ground potential (GND) is provided at the reference potential terminal (18),
wherein the laser circuit (10) comprises a digital circuit (65),
**characterized in**
**that** the digital circuit (65) is connected to the first supply terminal (11) and is coupled to the reference potential terminal (18), and
wherein the digital circuit (65) is directly connected to a control input of the video digital-to-analog converter (23).

2. Laser circuit (10) of claim 1,
wherein the video digital-to-analog converter (23) is realized as current source circuit.

3. Laser circuit (10) of claims 1 or 2,
wherein the laser circuit (10) is free of a level shifter having
- an input coupled to the digital circuit (65) and
- an output coupled to the control input of the video digital-to-analog converter (23).

4. Laser circuit (10) of one of claims 1 to 3,
wherein the video digital-to-analog converter (23) comprises a first number N of series circuits (51 to 53), and
wherein a series circuit of the first number N of series circuits (51 to 53) comprises a converter switch (54 to 56) and a current regulator (57 to 59).

5. Laser circuit (10) of one of claims 1 to 4,
wherein the laser circuit (10) comprises a bias digital-to-analog converter (70), wherein the first supply terminal (11) is coupled via the bias digital-to-analog converter (70) to the first terminal (21) of the laser (20).

6. Laser circuit (10) of claim 5,
wherein the bias digital-to-analog converter (70) is realized as current source circuit.

7. Laser circuit (10) of one of claims 1 to 6,
wherein the laser circuit (10) comprises a threshold digital-to-analog converter (80) that is coupled to the first terminal (21) of the laser (20).

8. Laser circuit (10) of one of claims 1 to 7,
wherein the laser circuit (10) comprises a gain digital-to-analog converter (75) having an output coupled to an input of the video digital-to-analog converter (23).

9. Laser circuit (10) of one of claims 1 to 8,
wherein the laser circuit (10) comprises
- a further video digital-to-analog converter (33),
- a further laser (30) with a first and a second terminal, and
- a further supply terminal (13) which is coupled to the second terminal of the further laser (30), and
wherein the first supply terminal (11) is coupled via the further video digital-to-analog converter (33) to the first terminal of the further laser (30).

10. Laser circuit (10) of one of claims 1 to 9,
wherein the laser circuit (10) comprises
- an additional video digital-to-analog converter (43),
- an additional laser (40) with a first and a second terminal, and
- an additional supply terminal (14) which is coupled to the second terminal of the additional laser (40), and
wherein the first supply terminal (11) is coupled via the additional video digital-to-analog converter (43) to the first terminal of the additional laser (40).

11. Arrangement (135), comprising the laser circuit (10) of one of claims 1 to 10,
wherein the arrangement (135) is realized as one of a group comprising head mounted display, head up display, AR wearable device, pico-projector, laser projection system, LIDAR, AR glasses, mixed reality glasses and VR glasses.

12. Method for operating a laser circuit (10), comprising
- providing a first supply voltage (VCC) to a video digital-to-analog converter (23),
- providing a video signal current (IVS) by the video digital-to-analog converter (23),
- providing a second supply voltage (VCA_R) to a laser (20), and
- emitting radiation by the laser (20) as a function of the video signal current (IVS),
wherein the first supply voltage (VCC) is higher than a ground potential (GND) and the second supply voltage (VCA_R) is lower than the ground potential (GND), wherein the first terminal (21) of the laser (20) is an anode of the laser (20) and the second terminal (22) of the laser (20) is a cathode of the laser (20),
wherein the laser circuit (10) comprises a reference potential terminal (18),
wherein the ground potential (GND) is provided at the reference potential terminal (18),
wherein the laser circuit (10) comprises a digital circuit (65) which is connected to the first supply terminal (11) and is coupled to the reference potential terminal (18), and
wherein the digital circuit (65) is directly connected to a control input of the video digital-to-analog converter (23).

13. Method of claim 12, comprising
- providing a threshold current (IT) by a threshold digital-to-analog converter (80) and
- emitting radiation by the laser (20) in addition as a function of the threshold current (IT).

14. Method of claim 12 or 13, comprising
- providing a bias current (IB) by a bias digital-to-analog converter (70) and
- emitting radiation by the laser (20) in addition as a function of the bias current (IB).

## Patentansprüche

1. Laserschaltung (10), umfassend
- einen Video-Digital-Analog-Wandler (23),
- einen Laser (20) mit einem ersten und einem zweiten Anschluss (21, 22),
- einen ersten Versorgungsanschluss (11), der über den Video-Digital-Analog-Wandler (23) mit dem ersten Anschluss (21) des Lasers (20) gekoppelt ist,
- einen zweiten Versorgungsanschluss (12), der mit dem zweiten Anschluss (22) des Lasers (20) gekoppelt ist,
wobei eine am ersten Versorgungsanschluss (11) bereitgestellte erste Versorgungsspannung (VCC) höher ist als ein Massepotential (GND) und
eine am zweiten Versorgungsanschluss (12) bereitgestellte zweite Versorgungsspannung (VCA_R) niedriger ist als das Massepotential (GND),
wobei der erste Anschluss (21) des Lasers (20) eine Anode des Lasers (20) ist und der zweite Anschluss (22) des Lasers (20) eine Kathode des Lasers (20) ist,
wobei die Laserschaltung (10) einen Referenzpotentialanschluss (18) umfasst,
wobei das Massepotential (GND) am Referenzpotentialanschluss (18) anliegt,
wobei die Laserschaltung (10) eine digitale Schaltung (65) umfasst,
**dadurch gekennzeichnet,**
**dass** die digitale Schaltung (65) mit dem ersten Versorgungsanschluss (11) verbunden und an den Referenzpotentialanschluss (18) gekoppelt ist, und
wobei die digitale Schaltung (65) direkt mit einem Steuereingang des Video-Digital-Analog-Wandlers (23) verbunden ist.

2. Laserschaltung (10) nach Anspruch 1,
wobei der Video-Digital-Analog-Wandler (23) als Stromquellenschaltung ausgeführt ist.

3. Laserschaltung (10) nach Anspruch 1 oder 2,
wobei die Laserschaltung (10) frei von einem Pegelumsetzer ist, der
- einen mit der Digitalschaltung (65) gekoppelten Eingang und
- einen mit dem Steuereingang des Video-Digital-Analog-Wandlers (23) gekoppelten Ausgang aufweist.

4. Laserschaltung (10) nach einem der Ansprüche 1 bis 3,
wobei der Video-Digital-Analog-Wandler (23) eine erste Anzahl N von Reihenschaltungen (51 bis 53) umfasst, und
wobei eine Reihenschaltung der ersten Anzahl N von Reihenschaltungen (51 bis 53) einen Wandlerschalter (54 bis 56) und einen Stromregler (57 bis 59) umfasst.

5. Laserschaltung (10) nach einem der Ansprüche 1 bis 4, wobei die Laserschaltung (10) einen Vorspannungs-Digital-Analog-Wandler (70) umfasst, wobei der erste Versorgungsanschluss (11) über den Vorspannungs-Digital-Analog-Wandler (70) mit dem ersten Anschluss (21) des Lasers (20) gekoppelt ist.

6. Laserschaltung (10) nach Anspruch 5,
wobei der Vorspannungs-Digital-Analog-Wandler (70) als Stromquellenschaltung ausgeführt ist.

7. Laserschaltung (10) nach einem der Ansprüche 1 bis 6,
wobei die Laserschaltung (10) einen Schwellenwert-Digital-Analog-Wandler (80) umfasst, der mit dem ersten Anschluss (21) des Lasers (20) gekoppelt ist.

8. Laserschaltung (10) nach einem der Ansprüche 1 bis 7, wobei die Laserschaltung (10) einen Verstärkungs-Digital-Analog-Wandler (75) umfasst, dessen Ausgang mit einem Eingang des Video-Digital-Analog-Wandlers (23) gekoppelt ist.

9. Laserschaltung (10) nach einem der Ansprüche 1 bis 8, wobei die Laserschaltung (10) umfasst
- einen weiteren Video-Digital-Analog-Wandler (33),
- einen weiteren Laser (30) mit einem ersten und einem zweiten Anschluss und
- einen weiteren Versorgungsanschluss (13), der mit dem zweiten Anschluss des weiteren Lasers (30) gekoppelt ist, und
wobei der erste Versorgungsanschluss (11) über den weiteren Video-Digital-Analog-Wandler (33) mit dem ersten Anschluss des weiteren Lasers (30) gekoppelt ist.

10. Laserschaltung (10) nach einem der Ansprüche 1 bis 9, wobei die Laserschaltung (10) umfasst
- einen zusätzlichen Video-Digital-Analog-Wandler (43),
- einen zusätzlichen Laser (40) mit einem ersten und einem zweiten Anschluss und
- einen zusätzlichen Versorgungsanschluss (14), der mit dem zweiten Anschluss des zusätzlichen Lasers (40) gekoppelt ist, und
wobei der erste Versorgungsanschluss (11) über den zusätzlichen Video-Digital-Analog-Wandler (43) mit dem ersten Anschluss des zusätzlichen Lasers (40) gekoppelt ist.

11. Anordnung (135), umfassend die Laserschaltung (10) gemäß einem der Ansprüche 1 bis 10,
wobei die Anordnung (135) als eines aus einer Gruppe realisiert ist, die Head-Mounted-Displays, Head-up-Displays, tragbare AR-Geräte, Pico-Projektoren, Laserprojektionssysteme, LIDAR, AR-Brillen, Mixed-Reality-Brillen und VR-Brillen umfasst.

12. Verfahren zum Betreiben einer Laserschaltung (10), umfassend
- Bereitstellen einer ersten Versorgungsspannung (VCC) für einen Video-Digital-Analog-Wandler (23),
- Bereitstellen eines Videosignalstroms (IVS) durch den Video-Digital-Analog-Wandler (23),
- Bereitstellen einer zweiten Versorgungsspannung (VCA_R) für einen Laser (20) und
- Aussenden von Strahlung durch den Laser (20) in Abhängigkeit vom Videosignalstrom (IVS),
wobei die erste Versorgungsspannung (VCC) höher ist als ein Massepotential (GND) und die zweite Versorgungsspannung (VCA_R) niedriger ist als das Massepotential (GND),
wobei der erste Anschluss (21) des Lasers (20) eine Anode des Lasers (20) ist und der zweite Anschluss (22) des Lasers (20) eine Kathode des Lasers (20) ist,
wobei die Laserschaltung (10) einen Referenzpotentialanschluss (18) umfasst,
wobei das Massepotential (GND) am Referenzpotentialanschluss (18) bereitgestellt wird, wobei die Laserschaltung (10) eine digitale Schaltung (65) umfasst, die mit dem ersten Versorgungsanschluss (11) verbunden und an den Referenzpotentialanschluss (18) gekoppelt ist, und
wobei die digitale Schaltung (65) direkt mit einem Steuereingang des Video-Digital-Analog-Wandlers (23) verbunden ist.

13. Verfahren nach Anspruch 12, umfassend
- Bereitstellen eines Schwellenstroms (IT) durch einen Schwellenwert-Digital-Analog-Wandler (80) und
- zusätzliches Aussenden von Strahlung durch den Laser (20) in Abhängigkeit vom Schwellenstrom (IT).

14. Verfahren nach Anspruch 12 oder 13, umfassend
- Bereitstellen eines Vorspannungsstroms (IB) durch einen Vorspannungs-Digital-Analog-Wandler (70) und
- das zusätzliche Aussenden von Strahlung durch den Laser (20) in Abhängigkeit vom Vorspannungsstrom (IB).

## Revendications

1. Circuit laser (10), comprenant
- un convertisseur numérique-analogique vidéo (23),
- un laser (20) comportant une première et une deuxième bornes (21, 22),
- une première borne d'alimentation (11) qui est couplée, via le convertisseur numérique-analogique vidéo (23), à la première borne (21) du laser (20),
- une deuxième borne d'alimentation (12) qui est couplée à la deuxième borne (22) du laser (20),
dans lequel une première tension d'alimentation (VCC) fournie à la première borne d'alimentation (11) est supérieure au potentiel de masse (GND) et
une deuxième tension d'alimentation (VCA_R) fournie à la deuxième borne d'alimentation (12) est inférieure au potentiel de masse (GND),
dans lequel la première borne (21) du laser (20) est une anode du laser (20) et la deuxième borne (22) du laser (20) est une cathode du laser (20),
dans lequel le circuit laser (10) comprend une borne de potentiel de référence (18),
dans lequel le potentiel de masse (GND) est fourni à la borne de potentiel de référence (18),
dans lequel le circuit laser (10) comprend un circuit numérique (65),
**caractérisé en ce que**
le circuit numérique (65) est connecté à la première borne d'alimentation (11) et est couplé à la borne de potentiel de référence (18), et
dans lequel le circuit numérique (65) est directement connecté à une entrée de commande du convertisseur numérique-analogique vidéo (23).

2. Circuit laser (10) selon la revendication 1,
dans lequel le convertisseur numérique-analogique vidéo (23) est réalisé sous la forme d'un circuit à source de courant.

3. Circuit laser (10) selon la revendication 1 ou 2,
dans lequel le circuit laser (10) ne comporte pas de convertisseur de niveau ayant
- une entrée couplée au circuit numérique (65) et
- une sortie couplée à l'entrée de commande du convertisseur numérique-analogique vidéo (23).

4. Circuit laser (10) selon l'une des revendications 1 à 3, dans lequel le convertisseur numérique-analogique vidéo (23) comprend un premier nombre N de circuits en série (51 à 53), et
dans lequel un circuit en série parmi le premier nombre N de circuits en série (51 à 53) comprend un commutateur de convertisseur (54 à 56) et un régulateur de courant (57 à 59).

5. Circuit laser (10) selon l'une des revendications 1 à 4, dans lequel le circuit laser (10) comprend un convertisseur numérique-analogique de polarisation (70), la première borne d'alimentation (11) étant couplée, via le convertisseur numérique-analogique de polarisation (70), à la première borne (21) du laser (20).

6. Circuit laser (10) selon la revendication 5,
dans lequel le convertisseur numérique-analogique de polarisation (70) est réalisé sous la forme d'un circuit à source de courant.

7. Circuit laser (10) selon l'une des revendications 1 à 6, dans lequel le circuit laser (10) comprend un convertisseur numérique-analogique de seuil (80) qui est couplé à la première borne (21) du laser (20).

8. Circuit laser (10) selon l'une des revendications 1 à 7, dans lequel le circuit laser (10) comprend un convertisseur numérique-analogique de gain (75) dont la sortie est couplée à une entrée du convertisseur numérique-analogique vidéo (23).

9. Circuit laser (10) selon l'une des revendications 1 à 8, dans lequel le circuit laser (10) comprend
- un autre convertisseur numérique-analogique vidéo (33),
- un autre laser (30) doté d'une première et d'une deuxième borne, et
- une autre borne d'alimentation (13) qui est couplée à la deuxième borne de l'autre laser (30), et
dans lequel la première borne d'alimentation (11) est couplée, via l'autre convertisseur numérique-analogique vidéo (33), à la première borne de l'autre laser (30).

10. Circuit laser (10) selon l'une des revendications 1 à 9, dans lequel le circuit laser (10) comprend
- un convertisseur numérique-analogique vidéo supplémentaire (43),
- un laser supplémentaire (40) doté d'une première et d'une deuxième borne, et
- une borne d'alimentation supplémentaire (14) qui est couplée à la deuxième borne du laser supplémentaire (40), et
dans lequel la première borne d'alimentation (11) est couplée, via le convertisseur numérique-analogique vidéo supplémentaire (43), à la première borne du laser supplémentaire (40).

11. Agencement (135), comprenant le circuit laser (10) selon l'une des revendications 1 à 10,
dans lequel l'agencement (135) est réalisé sous la forme d'un élément parmi un groupe comprenant un dispositif d'affichage monté sur la tête, un affichage tête haute, un dispositif portable de réalité augmentée, un picoprojecteur, un système de projection laser, un LIDAR, des lunettes de réalité augmentée, des lunettes de réalité mixte et des lunettes de réalité virtuelle.

12. Procédé de fonctionnement d'un circuit laser (10), comprenant
- fournir une première tension d'alimentation (VCC) à un convertisseur numérique-analogique vidéo (23),
- fournir un courant de signal vidéo (IVS) par le convertisseur numérique-analogique vidéo (23),
- fournir une deuxième tension d'alimentation (VCA_R) à un laser (20), et
- émettre un rayonnement par le laser (20) en fonction du courant de signal vidéo (IVS),
dans lequel la première tension d'alimentation (VCC) est supérieure à un potentiel de masse (GND) et la deuxième tension d'alimentation (VCA_R) est inférieure au potentiel de masse (GND),
dans lequel la première borne (21) du laser (20) est une anode du laser (20) et la deuxième borne (22) du laser (20) est une cathode du laser (20),
dans lequel le circuit laser (10) comprend une borne de potentiel de référence (18),
dans lequel le potentiel de masse (GND) est fourni à la borne de potentiel de référence (18),
dans lequel le circuit laser (10) comprend un circuit numérique (65) qui est connecté à la première borne d'alimentation (11) et est couplé à la borne de potentiel de référence (18), et
dans lequel le circuit numérique (65) est directement connecté à une entrée de commande du convertisseur numérique-analogique vidéo (23).

13. Procédé selon la revendication 12, comprenant
- la fourniture d'un courant de seuil (IT) par un convertisseur numérique-analogique de seuil (80) et
- l'émission, en outre, d'un rayonnement par le laser (20) en fonction du courant de seuil (IT).

14. Procédé selon la revendication 12 ou 13, comprenant
- la fourniture d'un courant de polarisation (IB) par un convertisseur numérique-analogique de polarisation (70) et
- l'émission, en outre, d'un rayonnement par le laser (20) en fonction du courant de polarisation (IB).
